# EUROPEAN PATENT APPLICATION

(11) **EP 4 827 280 A1**
(43) Date of publication of application: **21.10.2026**
(21) Application number: 26151774.2
(22) Date of filing: 14.01.2026
(51) Int. Cl.: H10F 39/18, H10F 39/00

(54) **IMAGE SENSOR INCLUDING AN AUTO FOCUS LENS AND METHOD OF OPERATING THE SAME**

(30) Priority: 14.04.2025 KR 20250048450
(71) Applicant: Samsung Electronics Co., Ltd., Suwon-si, Gyeonggi-do 16677 (KR)
(72) Inventor: LEE, Seungjoon, Suwon-si (KR); JIN, Younggu, Suwon-si (KR)
(74) Representative: Marks & Clerk LLP

(57) **Abstract**

The present disclosure relates to an image sensor and a method of operating the image sensor. An example image sensor include a first sub-pixel group (PGs11) including a first plurality of photodiodes (PD1 - PD8) arranged in a plurality of rows and a plurality of columns and sharing a first floating diffusion node (FD1), a second sub-pixel group (PGs12) adjacent to the first sub-pixel group (PGs11), and including a second plurality of photodiodes (PD9 - PD16) arranged in a plurality of rows and a plurality of columns and sharing a second floating diffusion node (FD2) separate from the first floating diffusion node (FD1), a color filter (CF1), at least a portion of which is disposed on the first sub-pixel group (PGs11) and the second sub-pixel group (PGs12), and a first lens (MLb), at least a portion of which is overlapped planarly with the first sub-pixel group (PGs11) and the second sub-pixel group (PGs12).

## Description

The invention relates to an image sensors and, in particular, an image sensor and a method of operating an image sensor including an autofocus lens.

### BACKGROUND

Demand for mobile devices such as smartphones, tablet PCs, digital cameras, and e-books is growing explosively, and most mobile devices are equipped with at least one image sensor to capture images. Vehicles are also equipped with image sensors to obtain various information necessary for driving, etc.

With the recent trend of increasing image resolution and miniaturizing image sensors, image sensors are adopting a shared type pixel array structure in which the plurality of photodiodes are electrically connected to the same floating diffusion. Although the shared type pixel array makes it easy to perform pixel binning techniques in low-light environments, the structural characteristics of image sensors that share floating diffusion limit the performance of some operations, such as limiting the operating speed.

One of these limitations is the limited performance of the auto focus (AF) function in high-light environments.

### SUMMARY

The present disclosure relates to an image sensor, a method of operating the image sensor that easily performs AF operation in a high-light environment where overflow occurs while increasing resolution, a method of operating the image sensor that easily performs AF operation over a wide dynamic range while increasing resolution, and a method of operating the image sensor that facilitates AF operation in a high-light environment while minimizing light loss.

In some implementations, an image sensor includes a first sub-pixel group including a first plurality of photodiodes arranged in a plurality of rows and a plurality of columns and sharing a first floating diffusion node, a second sub-pixel group adjacent to the first sub-pixel group, and including a second plurality of photodiodes arranged in a plurality of rows and a plurality of columns and sharing a second floating diffusion node separated from the first floating diffusion node, a color filter, at least a portion of which is disposed on the first sub-pixel group and the second sub-pixel group, and a first lens, at least a portion of which is overlapped planarly with the first sub-pixel group and the second sub-pixel group.

In some implementations, an image sensor includes, a first photodiode configured to receive light through a first lens to generate photocharges and electrically connected to a first floating diffusion node through a first transfer transistor, a second photodiode configured to receive light through a second lens to generate photocharges and electrically connected to the first floating diffusion node through a second transfer transistor, a first driving transistor configured to generate a first pixel signal in response to the voltage of the first floating diffusion node, a third photodiode configured to receive light through the first lens to generate photocharges and electrically connected to a second floating diffusion node separated from the first floating diffusion node through a third transfer transistor, a fourth photodiode configured to receive light through a third lens to generate photocharges and electrically connected to the second floating diffusion node through a fourth transfer transistor, a second driving transistor configured to generate a second pixel signal in response to the voltage of the second floating diffusion node, a color filter, at least a portion of which is disposed on the first photodiode to the fourth photodiode, and a read-out circuit configured to receive the first pixel signal through a first column line and the second pixel signal through a second column line separated from the first column line to generate image data based on the first pixel signal and the second pixel signal.

In some implementations, a method of operating an image sensor includes a step of resetting a first sub-pixel group sharing a first floating diffusion node and configured to output a pixel signal for a first color and a second sub-pixel group sharing a second floating diffusion node separated from the first floating diffusion node and configured to output a pixel signal for the first color, wherein at least a portion of the first sub-pixel group and at least a portion of the second sub-pixel group are overlapped planarly with a first lens, a step of receiving a first reset level signal from the first floating diffusion node and a second reset level signal from the second floating diffusion node together, a step of receiving a first pixel signal from the first floating diffusion node and a second pixel signal from the second floating diffusion node together in a first conversion gain mode, a step of changing the first conversion gain mode to a second conversion gain mode for the first sub-pixel group and the second sub-pixel group, a step of receiving a third pixel signal from the first floating diffusion node and a fourth pixel signal from the second floating diffusion node together in the second conversion gain mode, and a step of generating phase data based on the third pixel signal and the fourth pixel signal.

At least some of the above and other features of the invention are set out in the claims.

### BRIEF DESCRIPTION OF THE DRAWINGS

FIG. 1 is a block diagram illustrating an example of an image sensor.
FIG. 2 is a plan view illustrating an example of a pixel array.
FIGS. 3 and 4 are example enlarged views of the first pixel group of the pixel array of FIG. 2.
FIG. 5 is an example cross-sectional view taken along line I-I' of the first pixel group of FIG. 3.
FIG. 6 is an example cross-sectional view taken along line J-J' of the first pixel group of FIG. 3.
FIG. 7 is an example circuit diagram of a pixel group.
FIG. 8 is a timing diagram illustrating an example of AF operation of a pixel group.
FIGS. 9, 10, 11, 12, 13, 14, 15, and 16 are drawings for explaining an example of AF operation of pixel groups.
FIG. 17 is a plan view illustrating an example of a pixel array.
FIG. 18 is an example enlarged view of the first pixel group of the pixel array of FIG. 17.
FIG. 19 is an example circuit diagram of a pixel group.
FIG. 20 is a timing diagram illustrating an example of AF operation of a pixel group.
FIGS. 21, 22, 23, 24, 25, and 26 are drawings for explaining an example of AF operation of pixel groups.
FIG. 27 is a plan view illustrating examples of pixel groups.
FIG. 28 is a plan view illustrating examples of pixel groups.
FIG. 29 is a plan view illustrating examples of pixel groups.
FIG. 30 is a plan view illustrating examples of pixel groups.
FIG. 31 is a flowchart illustrating an example of a method of operating an image sensor.
FIG. 32 is a block diagram illustrating an example of a computer device.
FIG. 33 is a block diagram illustrating an example of a vehicle.

### DETAILED DESCRIPTION

Hereinafter, with reference to the attached drawings, several implementations of the present disclosure will be described in detail so that a person skilled in the art may easily implement the present disclosure. The present disclosure may be implemented in many different forms and is not limited to the implementations described herein.

In order to clearly explain the present disclosure, parts irrelevant to the description are omitted, and identical or similar reference numerals are given to identical or similar components throughout the specification.

Also, throughout the specification, when a part is referred to as "including" a component, this indicates that, unless specifically stated otherwise, it does not exclude the presence of other components and may further include additional components.

Additionally, a specific number set forth in a claim, even if explicitly recited in the claim, should not be construed as a limitation to the specific number in claims where such recitation does not exist. For example, subsequent dependent claims may include the phrases "at least one" and "one or more" to aid understanding. However, the use of such a construction should not be understood as being limited by the ambiguous article 'one', which is described for the sake of one example.

Moreover, when a convention such as 'at least one of A, B, or C' is used, such a phrase will be well understood by a person skilled in the art (i.e., 'a system comprising at least one of A, B, or C' includes, but is not limited to, A alone, B alone, C alone, A and B, A and C, B and C, and/or A, B, and C together). Or, words and/or phrases in the detailed description or claims or drawings having two or more separate alternative terms should be considered as possibly including one, or either, or both terms. For example, the phrase 'A or B' should be understood to include the possibilities of 'A', or 'B', or 'A and B'.

The terms "module," "unit," "part," and the like, as used in this document, are terms intended to refer to a component that performs at least one function or operation, and such a component may be implemented as hardware or software, or as a combination of hardware and software.

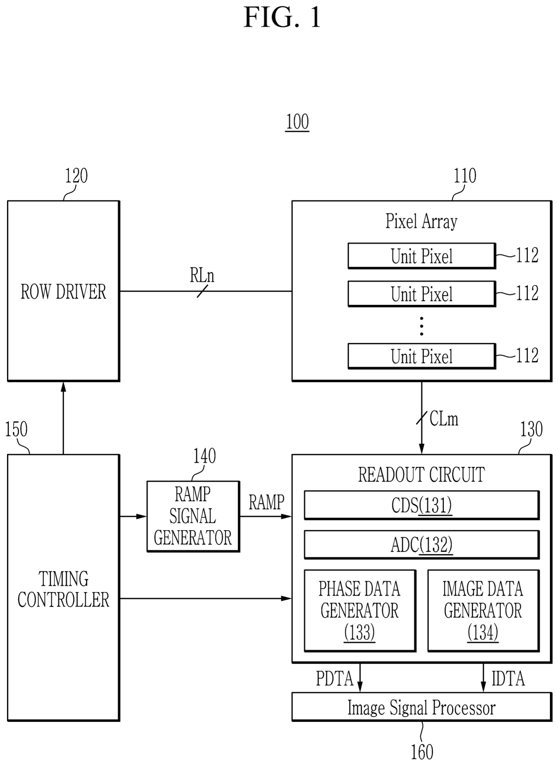

FIG. 1 is a block diagram illustrating an example of an image sensor.

Referring to FIG. 1, an image sensor 100 may be mounted on an electronic device having an image or light sensing function. For example, the image sensor 100 may be mounted on electronic devices such as a camera, a smartphone, a wearable device, an Internet of Things (IoT), a tablet PC (Personal Computer), a PDA (Personal Digital Assistant), a PMP (portable Multimedia Player), a navigation device, etc. Additionally, the image sensor 100 may be mounted on electronic devices provided as components in vehicles, furniture, manufacturing equipment, doors, various measuring devices, etc.

The image sensor 100 may include a pixel array 110, a row driver 120, a read-out circuit 130, a ramp signal generator 140, a timing controller 150, and an image signal processor 160.

In some implementations, the pixel array 110 may include a plurality of unit pixels 112. Each unit pixel 112 may include a plurality of photodiodes, a plurality of transfer transistors, a driving transistor, etc. A plurality of photodiodes may receive light to generate photocharges and provide the photocharges to a floating diffusion node through a plurality of transfer transistors, and generate a pixel signal in response to a potential according to the photocharges accumulated in the floating diffusion node. In some implementations, each unit pixel 112 may include a plurality of photodiodes arranged adjacent to each other in a plurality of rows and a plurality of columns. For example, each unit pixel 112 may include photodiodes arranged 4x2 adjacent to each other or photodiodes arranged 2x2 adjacent to each other.

Furthermore, the pixel array 110 may include a plurality of pixel groups, which are sets of a plurality of unit pixels 112. In some implementations, each pixel group may include unit pixels 112 arranged adjacent to each other and receiving light filtered by a color filter of the same color. In some implementations, a group of pixels may include photodiodes arranged 4x4 adjacent to each other.

In some implementations, the plurality of photodiodes may be arranged in a Tetra Quad Bayer pattern. In some implementations, a plurality of photodiodes may be arranged in an RGGB pattern with pixel groups arranged in a 4x4 arrangement as basic units.

In some implementations, a pixel group may include at least two photodiodes sharing the same microlens. The image sensor 100 may generate phase data as well as image data through the arrangement of shared lenses. In the present disclosure, the shared lens may be referred to as an AF lens.

In some implementations, each of the plurality of unit pixels 112 may include a shared pixel structure in which the plurality of photodiodes share a single floating diffusion node. In some implementations, a pixel group may have at least two shared floating diffusion nodes, and a photodiode within the pixel group may be electrically connected to one of the at least two shared floating diffusion nodes by a pixel drive signal.

In some implementations, the sharing relationship of the micro lenses of the plurality of photodiodes and the sharing relationship of the floating diffusion nodes of the plurality of photodiodes within a pixel group may be misaligned. Specifically, at least two photodiodes sharing the same micro-lens in one pixel group may be electrically connected to different shared floating diffusion nodes.

In some implementations, a unit pixel 112 may operate in a plurality-of-exposure mode, performing the plurality of exposures, or in a single-exposure-mode, performing one exposure in an integrated period. For example, a unit pixel 112 may operate in the plurality-of-exposure manner in which photocharges are generated through a photodiode in response to a single exposure operation in an integration period, and then additional photocharges are generated through the photodiode in response to an exposure operation in a read-out period after the integration period. As another example, a unit pixel 112 may operate in a single exposure manner, generating a photocharge via a photodiode after one exposure operation in the integration period.

The charge generated by the photodiode in each unit pixel 112 may be accumulated in a floating diffusion node, and the charge accumulated in the floating diffusion node may be converted into a voltage. At this time, the ratio at which the charge accumulated in the floating diffusion node is converted into voltage may be referred to as conversion gain. The conversion gain may be varied depending on the capacitance of the floating diffusion node.

Specifically, as the capacitance of the floating diffusion node increases, the conversion gain may decrease, and as the capacitance of the floating diffusion node decreases, the conversion gain may increase. In some implementations, each of the plurality of unit pixels 112 may operate in the plurality of conversion gain modes.

In some implementations, each of the plurality of unit pixels 112 may operate in a triple conversion gain mode. The triple conversion gain mode may include a high conversion gain mode, a middle conversion gain mode, and a low conversion gain mode. By way of example, the meaning of 'operating in triple conversion gain mode' may mean operating while continuously changing from high conversion gain mode to middle conversion gain mode, and from middle conversion gain mode to low conversion gain mode, and may include operating while continuously changing from low conversion gain mode to middle conversion gain mode, and from middle conversion gain mode to high conversion gain mode.

In some implementations, each of the plurality of unit pixels 112 may operate in a dual conversion gain mode. The dual conversion gain mode may include a high conversion gain mode and a low conversion gain mode. By way of example, the meaning of 'operating in dual conversion gain mode' may mean operating while continuously changing from a high conversion gain mode to a low conversion gain mode, and may include operating while continuously changing from a low conversion gain mode to a high conversion gain mode.

The rate at which charge is converted to voltage may be highest in high conversion gain mode and lowest in low conversion gain mode. Therefore, in the low conversion gain mode, a generation operation of a pixel signal suitable for a high-light environment may be performed more than in the middle conversion gain mode and the high conversion gain mode. In the middle conversion gain mode, a generation operation of a pixel signal suitable for a high-light environment may be performed more than in the high conversion gain mode.

The pixel array 110 may receive pixel driving signals including a reset signal, a transfer signal, a conversion gain enable signal, and a select signal from a row driver 120 through a plurality of row lines RLn. The pixel array 110 operates according to the received pixel driving signal, and each of the plurality of unit pixels 112 may convert an optical signal into a pixel signal, which is an analog signal.

The row driver 120 may select any one row of the pixel array 110 under the control of the timing controller 150. A row driver 120 may generate a select signal to select one of a plurality of rows. Additionally, the row driver 120 may activate reset signals and transfer signals for photodiodes corresponding to the selected row in a set order.

The pixel signal generated by each unit pixel 112 may be provided to the read-out circuit 130 through a plurality of column lines CLm. In this case, the pixel signal generated by each unit pixel 112 may include image information and phase information.

The read-out circuit 130 may include a correlated double sampler 131, an analog-to-digital converter 132, a phase data generator 133, and an image data generator 134.

The correlated double sampler 131 may include a plurality of comparators, each of which may compare a pixel signal received from a pixel array 110 through a plurality of column lines CLm with a ramp signal RAMP received from a ramp signal generator 140. Specifically, the correlated double sampler 131 may compare a received pixel signal with a ramp signal RAMP and output the comparison result to the analog-to-digital converter 132.

The correlated double sampler 131 may receive a reset level signal and a pixel signal generated from a photodiode of a selected row. Here, the reset level signal may be an analog signal corresponding to the reference voltage of the floating diffusion node, and the pixel signal may be an analog signal corresponding to the signal voltage of the floating diffusion node.

The analog-to-digital converter 132 may convert the comparison result of the correlated double sampler 131 into a digital signal and output it. In some implementations, the read-out circuit 130 includes an output buffer and may latch and output a digital signal of each column unit provided by the analog-to-digital converter 132 through the output buffer.

In some implementations, the phase data generator 133 may receive digital signals corresponding to at least two photodiodes included in a plurality of pixel groups. More specifically, the phase data generator 133 may receive digital signals corresponding to at least two photodiodes that share a micro lens among the photodiodes included in a plurality of pixel groups.

For example, the phase data generator 133 may receive digital signals corresponding to a photodiode located on the left side of at least two photodiodes sharing one micro lens, and extract first phase information by binning them. Additionally, the phase data generator 133 may receive digital signals corresponding to a photodiode located on the right side among at least two photodiodes sharing one micro lens, and extract second phase information by binning them.

The phase data generator 133 may generate phase data PDTA using the first phase information and the second phase information. For example, the phase data generator 133 may generate phase data PDTA by comparing the first phase information and the second phase information.

The read-out circuit 130 may receive pixel signals generated through different shared floating diffusion nodes within one pixel group and generate phase data PDTA based on the pixel signals. The image sensor 100 may simultaneously receive the plurality of pixel signals for one shared lens from different shared floating diffusion nodes in a high-light environment where overflow occurs through the shared relationship of micro lenses and the shared relationship of floating diffusion nodes within one pixel group.

In some implementations, the image data generator 134 may generate image data IDTA based on digital signals received from a plurality of pixels included in the pixel array 110. Specifically, the image data generator 134 may receive digital signals corresponding to at least two photodiodes that share a micro lens among the photodiodes included in a plurality of pixel groups, and generate image data IDTA based on the digital signals.

More specifically, the image data generator 134 may generate image data IDTA by synthesizing a digital signal based on pixel signals of a plurality of unit pixels 112.

For example, the image data generator 134 may receive a first digital signal corresponding to a photodiode located on the left side of one pixel group and a second digital signal corresponding to a photodiode located on the right side, respectively. Here, each of the first digital signal and the second digital signal may include image information and phase information. The image data generator 134 may generate image data IDTA by synthesizing the first digital signal and the second digital signal. At this time, the phase information of the first digital signal and the phase information of the second digital signal may be canceled out from each other.

In FIG. 1, the correlated double sampler 131 and the analog-to-digital converter 132 are illustrated as being implemented by being integrated into the read-out circuit 130, but this is not limited thereto, and depending on the implementation, the correlated double sampler 131 and the analog-to-digital converter 132 may be implemented in a configuration separated from the read-out circuit 130.

A ramp signal generator 140 may generate a ramp signal RAMP and transmit it to a read-out circuit 130. The ramp signal generator 140 may include a current source, a resistor, a capacitor, and the like. A ramp signal generator 140 may generate the plurality of ramp signals that fall or rise with a slope determined according to the current size of a variable current source or the resistance value of a variable resistor by controlling the ramp voltage, which is a voltage applied to a lamp resistor, by controlling the current size of a variable current source or the resistance value of a variable resistor.

The timing controller 150 may control at least some of the pixel array 110, the row driver 120, the read-out circuit 130, and the ramp signal generator 140. More specifically, the timing controller 150 may supply control signals, such as a clock signal, a timing control signal, etc., to the operations of the pixel array 110, the row driver 120, the read-out circuit 130, and the ramp signal generator 140.

The timing controller 150 may include a logic control circuit, a phase lock loop (PLL) circuit, a timing control circuit, and a communication interface circuit.

The timing controller 150 may control the timing of elements within the pixel array 110 in the reset period, integration period, and read-out period. The reset period may be a period in which charges accumulated in a floating diffusion node within the pixel array 110 are reset. The integration period may be a period where the photodiode is exposed to light and photocharges are generated. The read-out period may be a period in which a pixel signal based on a photocharge generated from a photodiode is transmitted to a read-out circuit 130.

The image signal processor 160 may perform image signal processing on image data IDTA and phase data PDTA received from the read-out circuit 130.

The image signal processor 160 may perform an AF operation to measure focus on a subject using phase data PDTA received from the read-out circuit 130. Additionally, the image signal processor 160 may generate an image of a subject using image data IDTA received from the read-out circuit 130.

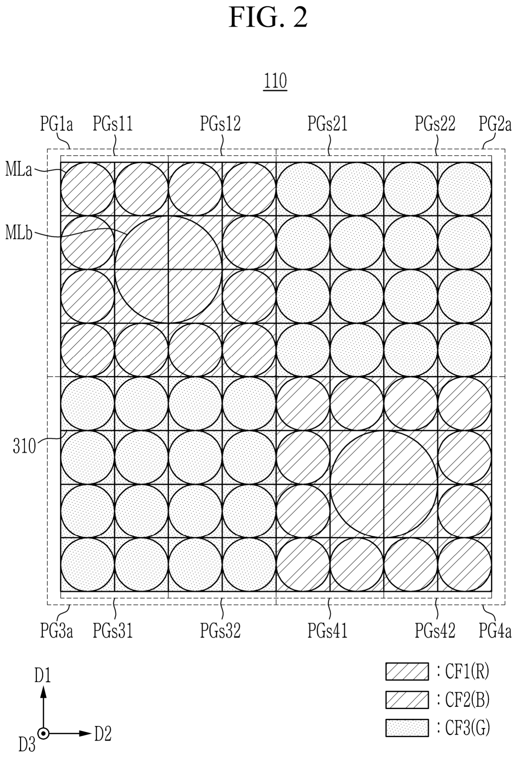

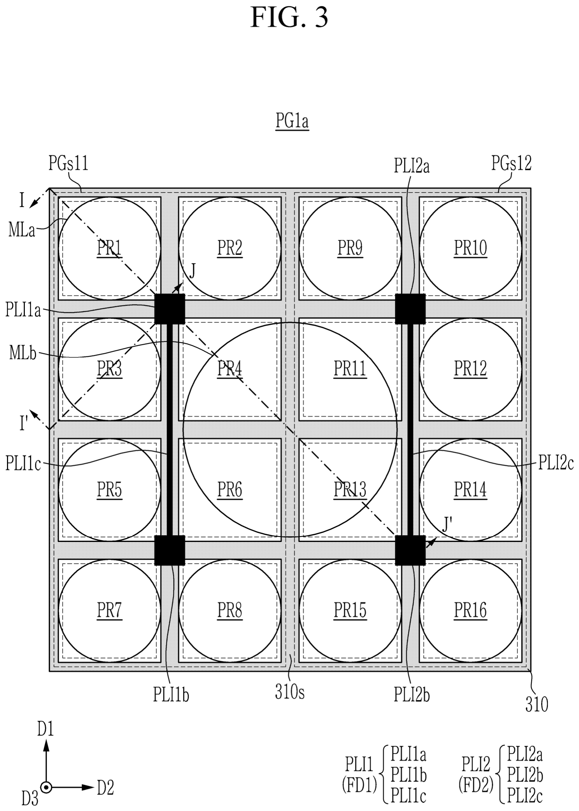

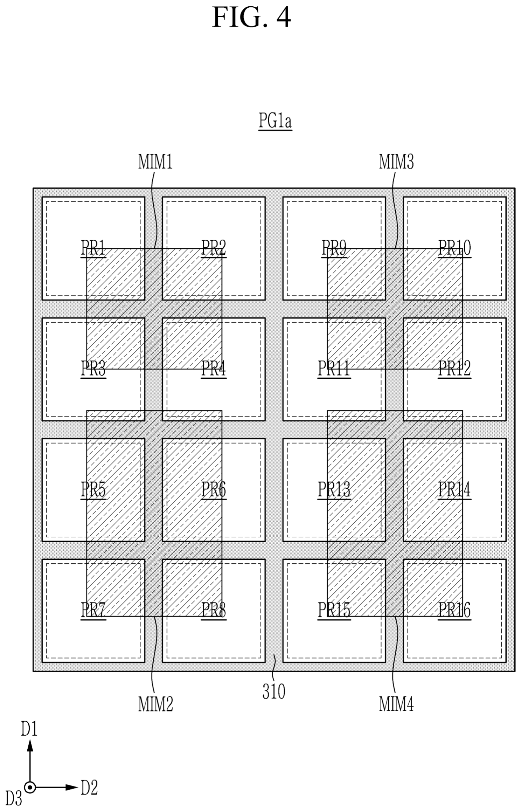

FIG. 2 is a plan view illustrating an example of a pixel array. FIGS. 3 and 4 are example enlarged views of the first pixel group of the pixel array of FIG. 2.

Referring to FIGS. 2 to 4, the pixel array 110 may include first to fourth pixel groups PG1a to PG4a. Each of the first to fourth pixel groups PG1a to PG4a may include photodiode regions arranged 4x4 in the first direction D1 and the second direction D2. The first pixel group PG1a and the second pixel group PG2a may be arranged in the second direction D2, and the third pixel group PG3a and the fourth pixel group PG4a may be arranged in the second direction D2. Additionally, the first pixel group PG1a and the third pixel group PG3a may be arranged in the first direction D1, and the second pixel group PG2a and the fourth pixel group PG4a may be arranged in the first direction D1.

The first to fourth pixel groups PG1a to PG4a may be distinguished and electrically isolated by a device isolation pattern 310. Additionally, the photodiode regions within the first to fourth pixel groups PG1a to PG4a may be separated and electrically isolated by a device isolation pattern 310. In the present disclosure, the photodiode region may be a region where photodiodes are arranged, and a plurality of photodiodes may be electrically separated by a device isolation pattern 310.

For convenience of explanation in this disclosure, each pixel group is illustrated as including a photodiode region arranged in a 4x4 arrangement, but is not limited thereto, and a pixel group may include a plurality of photodiodes arranged in various combinations (e.g., in an mxn arrangement, where m and n are both arbitrary natural numbers).

Each of the first to fourth pixel groups PG1a to PG4a may receive light filtered with the same color. In some implementations, the first to fourth pixel groups PG1a to PG4a may be arranged in an RGGB pattern with the pixel group as a basic unit, and a plurality of photodiodes within the first to fourth pixel groups PG1a to PG4a may be arranged in a tetra-quad Bayer pattern. Referring to FIG. 2 as an example, pixels of a first pixel group PG1a may receive red light R filtered by a first color filter CF1, pixels of a fourth pixel group PG4a may receive blue light B filtered by a second color filter CF2, and pixels of a second pixel group PG2a and a third pixel group PG3a may receive green light G filtered by a third color filter CF3.

Although not illustrated, the pixel array 110 may further include pixel groups arranged in the first direction D1 or the second direction D2 in addition to the first to fourth pixel groups PG1a to PG4a.

The a-th micro lens MLa and the b-th micro lens MLb may be arranged on the pixel array 110 with different pixel groups. Referring to FIG. 2 as an example, the a-th micro lens MLa and the b-th micro lens MLb may be arranged on the first pixel group PG1a that receives red light R and the fourth pixel group PG4a that receives blue light B, and the a-th micro lens MLa may be arranged on the second pixel group PG2a and the third pixel group PG3a that receive green light G.

The a-th micro lens MLa corresponds to one photodiode, and at least a portion of the a-th micro lens MLa overlaps the one photodiode planarly with respect to the third direction D3 and may focus incident light onto the one photodiode. The image sensor 100 may generate image data IDTA of FIG. 1 through photodiodes corresponding to the a-th micro lens MLa. A photodiode corresponding to the a-th micro lens MLa may be used for image generation purposes. The b-th micro lens MLb corresponds to the photodiodes arranged in a 2×2 array, and at least a portion of the microlens may overlap the photodiodes planarly and focus incident light onto the photodiodes. In some implementations, the photodiodes arranged 2×2 among the first pixel group PG1a and the fourth pixel group PG4a may share the b-th micro lens MLb, and the image sensor 100 may generate the image data IDTA and the phase data PDTA of FIG. 1 through the photodiodes sharing the b-th micro lens MLb. Photodiodes sharing the b-th micro lens MLb may be used for a variety of purposes, including image generation and phase detection.

The image sensor 100 may receive green light G, which is responsible for the luminance information of the user's eye, without light loss through the arrangement of the micro lenses MLa, MLb as described above, and receive red light R and blue light B, which are responsible for color information, through multipurpose photodiodes for phase difference detection and image generation, thereby enabling high-resolution image quality and accurate AF performance to be achieved simultaneously.

In the drawing, the micro lenses MLa, MLb and the device isolation pattern 310 are illustrated to be aligned and arranged, but this is not limited thereto, and the degree of alignment between the micro lenses MLa, MLb and the device isolation pattern 310 may vary depending on the position of the corresponding photodiode.

Each of the first to fourth pixel groups PG1a to PG4a may include two sub-pixel groups arranged left and right, and a plurality of photodiodes within each sub-pixel group may share a floating diffusion node, a reset transistor, a conversion gain transistor, a MIM (Metal-Insulator-Metal) capacitor, and a driving transistor. The image sensor 100 may be miniaturized and provide high-resolution images through a shared structure of each sub-pixel group. Each sub-pixel group may correspond to a unit pixel 112 of FIG. 1.

The first pixel group PG1a may include a 1_1 sub-pixel group PGs11 and a 1_2 sub-pixel group PGs12 arranged adjacently in the second direction D2, and the second pixel group PG2a may include a 2_1 sub-pixel group PGs21 and a 2_2 sub-pixel group PGs22 arranged adjacently in the second direction D2. Similarly, the third pixel group PG3a may include a 3_1 sub-pixel group PGs31 and a 3_2 sub-pixel group PGs32 arranged adjacently in the second direction D2, and the fourth pixel group PG4a may include a 4_1 sub-pixel group PGs41 and a 4_2 sub-pixel group PGs42 arranged adjacently in the second direction D2.

Below, for ease of explanation, the sub-pixel groups will be described focusing on the 1_1 sub-pixel group PGs11 and the 1_2 sub-pixel group PGs12. The description of the 1_1 sub-pixel group PGs11 and the 1_2 sub-pixel group PGs12 below may be applied to other sub-pixel groups within the pixel array 110.

The 1_1 sub-pixel group PGs11 and the 1_2 sub-pixel group PGs12 may be separated by a pixel group separation region 310s extending in the first direction D1. The pixel group separation region 310s is a portion of the device isolation pattern 310, and the 1_1 sub-pixel group PGs11 and the 1_2 sub-pixel group PGs12 may be separated in the second direction D2 by the pixel group separation region 310s.

The 1_1 sub-pixel group PGs11 may include first to eighth photodiode regions PR1 to PR8 arranged in a 4×2 array in the first direction D1 and the second direction D2, and the 1_2 sub-pixel group PGs12 may include ninth to sixteenth photodiode regions PR9 to PR16 arranged in a 4×2 array in the first direction D1 and the second direction D2. A photodiode may be arranged in each of the first to sixteenth photodiode regions PR1 to PR16.

The first to eighth photodiode regions PR1 to PR8 share a first floating diffusion node FD1, and the photodiodes of the first to eighth photodiode regions PR1 to PR8 may be electrically connected to the first floating diffusion node FD1. The ninth to sixteenth photodiode regions PR9 to PR16 share a second floating diffusion node FD2, and the photodiodes of the ninth to sixteenth photodiode regions PR9 to PR16 may be electrically connected to the second floating diffusion node FD2. The first floating diffusion node FD1 and the second floating diffusion node FD2 may be electrically isolated from each other.

The first floating diffusion node FD1 may include a first poly local interconnect PLI1. The first poly local interconnect PLI1 may include a first_a contact region PLI1a, a first_b contact region PLI1b, and a first connection region PLI1c. At least a portion of the first_a contact region PLI1a may overlap planarly with the first to fourth photodiode regions PR1 to PR4, and at least a portion of the first_b contact area PLI1b may overlap planarly with the fifth to eighth photodiode regions PR5 to PR8. The first connection region PLI1c connects the first_a contact region PLI1a and the first_b contact region PLI1b, extends along the first direction D1, and may overlap at least a portion of the device isolation pattern 310 planarly.

The first poly local interconnect PLI1 includes a conductive pattern, wherein the conductive pattern may include at least one of doped polysilicon, a metal, a metal silicide, a metal nitride, or a metal-containing film. For example, the first poly local interconnect PLI1 may be made of polysilicon doped with an N-type impurity, such as phosphorus (P) or arsenic (As).

The second floating diffusion node FD2 may include a second poly local interconnect PLI2. The second poly local interconnect PLI2 may include a second_a contact region PLI2a, a second_b contact region PLI2b, and a second connection region PLI2c. At least a portion of the second_a contact region PLI2a may be planarly overlapped with the ninth to twelfth photodiode regions PR9 to PR12, and at least a portion of the second_b contact area PLI2b may be planarly overlapped with the thirteenth to sixteenth photodiode regions PR13 to PR16. The second connection region PLI2c connects the second_a contact region PLI2a and the second_b contact region PLI2b, extends along the first direction D1, and may overlap at least a portion of the device isolation pattern 310 planarly.

The second poly local interconnect PLI2 includes a conductive pattern, wherein the conductive pattern may include at least one of doped polysilicon, a metal, a metal silicide, a metal nitride, or a metal-containing film. For example, the second poly local interconnect PLI2 may be made of polysilicon doped with an N-type impurity, such as phosphorus (P) or arsenic (As).

Additionally, a pixel group separation region 310s may be placed between the first poly local interconnect PLI1 and the second poly local interconnect PLI2.

Although not illustrated, an insulating spacer may be positioned extending along the sidewall of each of the first poly local interconnect PLI1 and the second poly local interconnect PLI2.

The a-th micro lens MLa may be positioned on the first photodiode region PR1, the second photodiode region PR2, the third photodiode region PR3, the fifth photodiode region PR5, the seventh photodiode region PR7, and the eighth photodiode region PR8 among the 1_1 sub-pixel group PGs11. Each of the first photodiode region PR1, the second photodiode region PR2, the third photodiode region PR3, the fifth photodiode region PR5, the seventh photodiode region PR7, and the eighth photodiode region PR8 corresponds to the a-th micro lens MLa, receives red light R filtered by the first color filter CF1, and may output a pixel signal for the red light R.

The a-th micro lens MLa may be arranged on the ninth photodiode region PR9, the tenth photodiode region PR10, the twelfth photodiode region PR12, the fourteenth photodiode region PR14, the fifteenth photodiode region PR15, and the sixteenth photodiode region PR16 among the 1_2 sub-pixel groups PGs12, respectively. Each of the ninth photodiode region PR9, the tenth photodiode region PR10, the twelfth photodiode region PR12, the fourteenth photodiode region PR14, the fifteenth photodiode region PR15, and the sixteenth photodiode region PR16 corresponds to the a-th micro lens MLa, receives red light R filtered by the first color filter CF1, and may output a pixel signal for the red light R.

The read-out circuit 130 of FIG. 1 may receive a pixel signal for a photodiode corresponding to the a-th micro lens MLa and generate image data IDTA of FIG. 1.

The b-th micro lens MLb may be arranged across the 1_1 sub-pixel group PGs11 and the 1_2 sub-pixel group PGs12, and may be arranged on the fourth photodiode region PR4, the sixth photodiode region PR6, the eleventh photodiode region PR11, and the thirteenth photodiode region PR13. The fourth photodiode region PR4, the sixth photodiode region PR6, the eleventh photodiode region PR11, and the thirteenth photodiode region PR13 may share the b-th micro lens MLb, and each of the fourth photodiode region PR4, the sixth photodiode region PR6, the eleventh photodiode region PR11, and the thirteenth photodiode region PR13 may receive red light R filtered by the first color filter CF1 and output a pixel signal for the red light R.

The read-out circuit 130 of FIG. 1 may receive a pixel signal for a photodiode corresponding to the b-th micro lens MLb and generate image data IDTA or phase data PDTA of FIG. 1. The read-out circuit 130 receives pixel signals corresponding to the photodiodes of the fourth photodiode region PR4 and the sixth photodiode region PR6 located on the left among the fourth photodiode region PR4, the sixth photodiode region PR6, the eleventh photodiode region PR11, and the thirteenth photodiode region PR13 to extract first phase information, and receives pixel signals corresponding to the photodiodes of the eleventh photodiode region PR11 and the thirteenth photodiode region PR13 located on the right to extract second phase information. The read-out circuit 130 may generate phase data PDTA by comparing the first phase information and the second phase information. The read-out circuit 130 may substantially simultaneously receive pixel signals for photodiodes of the fourth photodiode region PR4, the sixth photodiode region PR6, the eleventh photodiode region PR11, and the thirteenth photodiode region PR13 through a separation structure for the first and second floating diffusion nodes FD1, FD2.

Additionally, the read-out circuit 130 of FIG. 1 may generate image data IDTA based on pixel signals for photodiodes of the fourth photodiode region PR4, the sixth photodiode region PR6, the eleventh photodiode region PR11, and the thirteenth photodiode region PR13.

Each of the first MIM capacitor MIM1 and the second MIM capacitor MIM2 is shared by the 1_1 sub-pixel group PGs11 and may overlap planarly at least a portion of the 1_1 sub-pixel group PGs11. Similarly, each of the third MIM capacitor MIM3 and the fourth MIM capacitor MIM4 is shared by the 1_2 sub-pixel group PGs12 and may overlap planarly with at least a portion of the 1_2 sub-pixel group PGs12. Referring to FIG. 4 as an example, the first MIM capacitor MIM1 may be planarly overlapped with at least a portion of the first to fourth photodiode regions PR1 to PR4, and the second MIM capacitor MIM2 may be planarly overlapped with at least a portion of the third to eighth photodiode regions PR3 to PR8. The third MIM capacitor MIM3 may be planarly overlapped with at least a portion of the ninth to twelfth photodiode regions PR9 to PR12, and the fourth MIM capacitor MIM4 may be planarly overlapped with at least a portion of the eleventh to sixteenth photodiode regions PR11 to PR16.

Each of the first to fourth MIM capacitors MIM1 to MIM4 may include at least two metal films that overlap each other planarly in the 1_1 sub-pixel group PGs11 and an insulating film interposed between the at least two metal films. The metal film may include, but is not limited to, tungsten (W), aluminum (Al), copper (Cu), or a combination thereof.

The first to fourth MIM capacitors MIM1 to MIM4 and micro lenses MLa, MLb may be arranged to face each other based on the 1_1 and 1_2 sub-pixel groups PGs11, PGs12. For example, if the first and second MIM capacitors MIM1, MIM2 are arranged on the front surface of the 1_1 sub-pixel group PGs11, the micro lenses MLa, MLb may be arranged on the rear surface of the 1_1 sub-pixel group PGs11.

Although not illustrated, one electrode of each of the first MIM capacitor MIM1 and the second MIM capacitor MIM2 may be electrically connected to the first floating diffusion node FD1 based on a conversion gain enable signal. Depending on the electrical connection between the first floating diffusion node FD1 and the first and second MIM capacitors MIM1, MIM2, the charge storage capacity (Full Well Capacity) and the conversion gain mode for the 1_1 sub-pixel group PGs11 may be changed.

Similarly, one electrode of each of the third MIM capacitor MIM3 and the fourth MIM capacitor MIM4 may be electrically connected to the second floating diffusion node FD2 based on the conversion gain enable signal. Depending on the electrical connection between the second floating diffusion node FD2 and the third and fourth MIM capacitors MIM3, MIM4, the charge storage capacity and conversion gain mode for the 1_2 sub-pixel group PGs12 may be changed.

Each of the first to fourth MIM capacitors MIM1 to MIM4 may be a lateral overflow integration capacitor (LOFIC). If the first to fourth MIM capacitors MIM1 to MIM4 are LOFIC, charges that overflow among photocharges transferred from the photodiodes of the first photodiode region PR1 to the eighth photodiode region PR8 to the first floating diffusion node FD1 may be stored in at least one of the first MIM capacitor MIM1 and the second MIM capacitor MIM2, and charges that overflow among photocharges transferred from the photodiodes of the ninth photodiode region to the sixteenth photodiode region PR9 to PR16 to the second floating diffusion node FD2 may be stored in at least one of the third MIM capacitor MIM3 and the fourth MIM capacitor MIM4. That is, a large amount of overflowing charge is not discarded and may be integrated into the first to fourth MIM capacitors MIM1 to MIM4.

The area of the metal film in the first MIM capacitor MIM1 and the area of the metal film in the second MIM capacitor MIM2 may be different from each other, and the charge storage capacity of the first MIM capacitor MIM1 and the charge storage capacity of the second MIM capacitor MIM2 may be different from each other. The area of the metal film in the third MIM capacitor MIM3 and the area of the metal film in the fourth MIM capacitor MIM4 may be different from each other, and the charge storage capacity of the third MIM capacitor MIM3 and the charge storage capacity of the fourth MIM capacitor MIM4 may be different from each other. Through the difference in charge storage capacitance of the first MIM capacitor MIM1 and the second MIM capacitor MIM2 and the difference in charge storage capacitance of the third MIM capacitor MIM3 and the fourth MIM capacitor MIM4, the image sensor may efficiently adjust the conversion gain depending on the illumination environment.

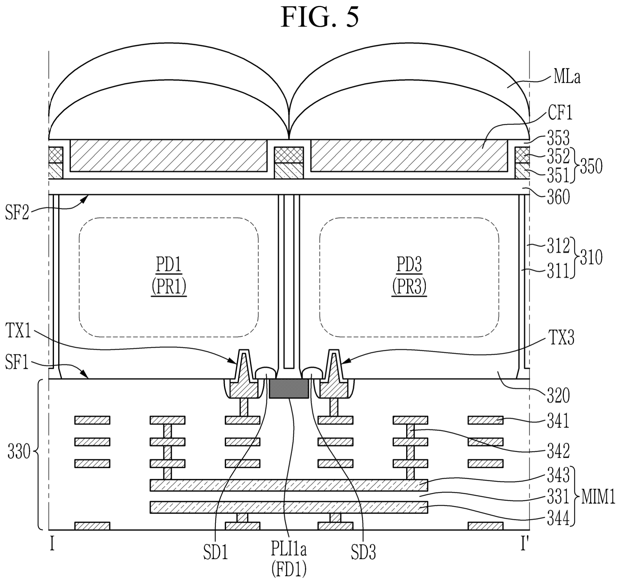

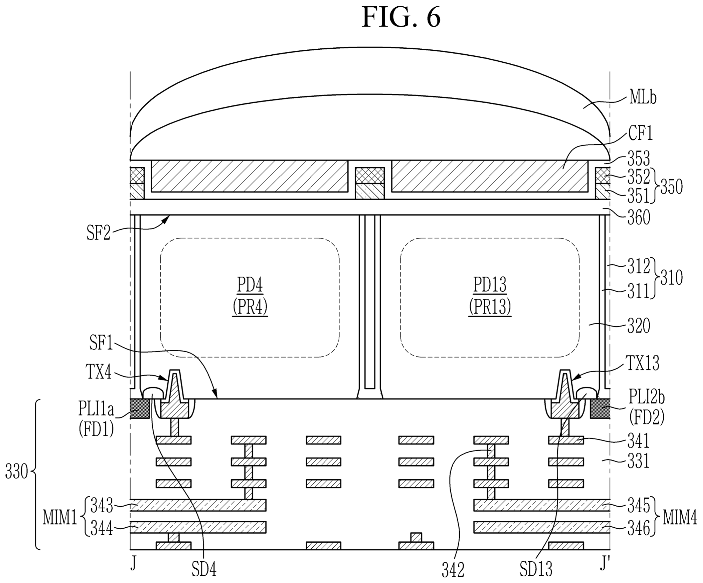

FIG. 5 is an example cross-sectional view taken along line I-I' of the first pixel group of FIG. 3. FIG. 6 is an example cross-sectional view taken along line J-J' of the first pixel group of FIG. 3. Specifically, FIGS. 5 and 6 are cross-sectional views illustrating a portion of the pixel array 110 of FIGS. 1 and 2.

Referring to FIGS. 2 to 6, an image sensor may include a semiconductor substrate 320, a wiring layer 330, a color filter grid 350, a surface insulating layer 360, color filters CF1 to CF3, and micro lenses MLa, MLb.

The semiconductor substrate 320 may be a semiconductor substrate. For example, the semiconductor substrate 320 may be bulk silicon or silicon-on-insulator SOI. The semiconductor substrate 320 may be a silicon substrate, or may include a semiconductor material including other materials, for example, silicon germanium, indium antimonide, lead tellurium compound, indium arsenide, indium phosphide, gallium arsenide, or gallium antimonide. Alternatively, the semiconductor substrate 320 may have an epi layer formed on a base substrate.

The semiconductor substrate 320 may include a first surface SF1 and a second surface SF2 that are opposite to each other. In some implementations, the first surface SF1 may be referred to as the front side of the semiconductor substrate 320, and the second surface SF2 may be referred to as the back side of the semiconductor substrate 320. In some implementations, the second surface SF2 of the semiconductor substrate 320 may be a light-receiving surface on which light is incident and a plurality of photodiodes are exposed. That is, the image sensor may be a backside illuminated BSI image sensor.

A plurality of pixel groups PG1a to PG4a may be arranged on a semiconductor substrate 320. The semiconductor substrate 320 includes a photodiode arranged in each photodiode region and a device isolation pattern 310 that separates the photodiodes, and a transfer transistor corresponding to each photodiode may be arranged on a first surface SF1 of the semiconductor substrate 320. Additionally, micro lenses MLa, MLb and color filters CF1 to CF3 may be arranged on each of the plurality of pixel groups PG1a to PG4a.

A photodiode may generate photocharges proportional to the amount of light incident on it from outside. For example, the photodiode may be a light-sensitive device made of organic or inorganic materials, such as an inorganic photodiode, an organic photodiode, a perovskite photodiode, a phototransistor, a photogate, or a pinned photodiode. A photodiode may be formed by doping impurities into a semiconductor substrate 320. For example, if the semiconductor substrate 320 is doped with P-type impurities, the photodiode may be doped with N-type impurities. That is, the type of impurity doped into the semiconductor substrate 320 and the type of impurity doped into the photodiode may be different from each other.

Taking FIG. 5 and FIG. 6 as examples, the first photodiode PD1 of the first photodiode region PR1 and the third photodiode PD3 of the third photodiode region PR3 may be separated by the device isolation pattern 310, and the fourth photodiode PD4 of the fourth photodiode region PR4 and the thirteenth photodiode PD13 of the thirteenth photodiode region PR13 may be separated by the device isolation pattern 310. Additionally, a first transfer transistor TX1, a third transfer transistor TX3, a fourth transfer transistor TX4, and a thirteenth transfer transistor TX13 may be arranged on a first surface SF1 of a semiconductor substrate 320. A first color filter CF1 may be arranged on the first photodiode region PR1, the third photodiode region PR3, the fourth photodiode region PR4, and the thirteenth photodiode region PR13 of the first pixel group PG1a. Additionally, the a-th micro lens MLa may be disposed on each of the first photodiode region PR1 and the third photodiode region PR3, and the b-th micro lens MLb may be disposed on each of the fourth photodiode region PR4 and the thirteenth photodiode region PR13.

A transfer transistor corresponding to each photodiode may be implemented with a vertical transfer gate (VTG) structure and may be placed adjacent to a poly local interconnect shared within a sub-pixel group. The contact area of the poly local interconnect is in contact with an impurity region corresponding to the source/drain of the transfer transistor, and the poly local interconnect and the impurity region in the semiconductor substrate 320 in contact may form a shared floating diffusion node. Taking FIG. 5 and FIG. 6 as examples, the first_a contact region PLI1a is in contact with the first transfer transistor TX1, the third transfer transistor TX3, and the impurity regions SD1, SD3, SD4 of the third transfer transistor TX3, and the first poly local interconnect PLI1 and the impurity region in the semiconductor substrate 320 in contact may form a first floating diffusion node FD1. Additionally, the second_b contact region PLI2b of the second poly local interconnect PLI2 is in contact with the impurity region SD13 of the thirteenth transfer transistor TX13, and the second poly local interconnect PLI2 and the impurity region of the semiconductor substrate 320 in contact may form a second floating diffusion node FD2.

Through the contact structure of the poly local interconnect and the impurity region of the transfer transistor, the image sensor 100 may omit the plurality of contacts to form a shared floating diffusion node and reduce parasitic capacitance for the floating diffusion node formed between the plurality of contacts. Through the improved parasitic capacitor structure for the shared floating diffusion node, the image sensor 100 may operate with high sensitivity in high conversion gain mode.

Although not illustrated, at least some of the various transistors (e.g., a transfer transistor, a reset transistor, a driving transistor, a conversion gain transistor, and a select transistor) for operating the pixels within the pixel group may be disposed on the first surface SF1.

The device isolation pattern 310 is arranged in a mesh shape within the semiconductor substrate 320, and a plurality of photodiode regions may be divided and electrically separated according to the mesh shape. A plurality of photodiode regions may be arranged in a two-dimensional grid shape along the first direction D1 and the second direction D2 from a planar viewpoint. The device isolation pattern 310 may be formed by filling an insulating material into a deep trench formed by patterning a semiconductor substrate 320.

At least a portion of the device isolation pattern 310 may be planarly overlapped and in contact with the poly local interconnects PLI1, PLI2.

In some implementations, the device isolation pattern 310 may include an insulating spacer film 311 and a conductive filling pattern 312. The insulating spacer film 311 may extend along the side of the trench in the semiconductor substrate 320. The conductive filling pattern 312 may be formed on an insulating spacer film 311 to fill a portion of a trench in a semiconductor substrate 320. In some implementations, the insulating spacer film 311 may have a structure in which the width increases as it approaches the first surface SF1.

In the drawing, the insulating spacer film 311 is depicted as being implemented as a single material layer, but according to an implementation, an insulating material layer distinct from the insulating spacer film 311 may be placed between the first surface SF1 and the conductive filling pattern 312. The above-described insulating material layers may be arranged according to a shallow trench structure formed on an insulating spacer film 311 and a conductive filling pattern 312.

A surface insulating layer 360 may be laminated on the second surface SF2 of the semiconductor substrate 320. The color filter grid 350, liner 353, color filters CF1 to CF3, and micro lenses MLa, MLb may be placed in an area defined by the surface insulating layer 360.

Color filters CF1 to CF3 may be formed on the surface insulating layer 360. Color filters CF1 to CF3 may be arranged to correspond to pixel groups. Color filters CF1 to CF3 may be arranged two-dimensionally from a planar perspective. The color filters CF1 to CF3 may include a first color filter CF1 which is a red color filter, a second color filter CF2 which is a blue color filter, and a third color filter CF3 which is a green color filter.

Micro lenses MLa, MLb may be formed on the color filter. The a-th micro lens MLa is arranged to correspond to one photodiode and may be placed on the first to third color filters CF1 to CF3. In some implementations, a photodiode corresponding to the a-th micro lens MLa may be used for image generation purposes. The b-th micro lens MLb are arranged to correspond to a plurality of photodiode regions arranged in a 2×2 arrangement and may be placed on the first and second color filters CF1, CF2. Additionally, one of the b-th micro lens MLb may be positioned across different groups of adjacent sub-pixels. Referring to FIG. 6 as an example, the b-th micro lens MLb may be arranged across the fourth photodiode region PR4 of the 1_1 sub-pixel group PGs11 and the thirteenth photodiode region PR13 of the 1_2 sub-pixel group PGs12. A plurality of photodiodes corresponding to the b-th micro lens MLb may be used for image generation and phase detection purposes.

Micro lenses MLa, MLb have a convex shape and may have a predetermined radius of curvature. The micro lenses MLa, MLb may include, but are not limited to, a light-transmitting resin, for example.

The color filter grid 350 may be arranged in a mesh shape between the color filters CF1 to CF3, and may define an area in which the color filters CF1 to CF3 are arranged in the mesh shape. Therefore, at least a portion of the color filter grid 350 may be planarly overlapped with the device isolation pattern 310.

A color filter grid 350 may be formed on a surface insulating layer 360. The color filter grid 350 may include, for example, a metal pattern 351 and a low refractive index pattern 352. The metal pattern 351 and the low refractive index pattern 352 may be sequentially laminated on the surface insulating layer 360.

A liner 353 may be formed on the surface insulating layer 360 and the color filter grid 350. The liner 353 may extend along the surface of the surface insulating layer 360 and the color filter grid 350. The liner 353 may include, for example, but is not limited to, aluminum oxide.

The wiring layer 330 may include an interlayer insulating film 331, a plurality of wirings 341, a plurality of contacts 342, and a MIM capacitor. Electronic components within the pixel array 110 may be electrically connected to each other through a wiring layer 330.

A plurality of wires 341 are arranged in a plurality of layers within the interlayer insulating film 331, and a plurality of contacts 342 extend in a third direction D3 within the interlayer insulating film 331 to electrically connect a plurality of wires 341, a MIM capacitor, a transistor, and the like. Referring to FIG. 5 as an example, some of the plurality of contacts 342 may electrically connect between the gate of the first transfer transistor TX1 and the plurality of wires 341, and some of the plurality of contacts 342 may electrically connect between the plurality of wires 341 and the first MIM capacitor MIM1.

The interlayer insulating film 331 may include at least one of silicon oxide, silicon nitride, silicon oxynitride, and a low-k material having a lower dielectric constant than silicon oxide, but is not limited thereto. The plurality of wires 341 and the plurality of contacts 342 include a conductive material, and may include, for example, but not limited to, at least one of copper (Cu), aluminum (Al), tungsten (W), gold (Au), silver (Ag), and alloys thereof.

A MIM capacitor may include at least two metal films that overlap each other planarly in a third direction D3 and a portion of an interlayer insulating film 331 interposed between the at least two metal films. At least a portion of the MIM capacitor may be planarly overlapped with a plurality of pixels.

Taking the first MIM capacitor MIM1 and the fourth MIM capacitor MIM4 of FIGS. 5 and 6 as examples, the first MIM capacitor MIM1 may include first and second metal films 343, 344 that overlap each other planarly in the third direction D3 and a portion of an interlayer insulating film 331 interposed between the first and second metal films 343, 344. The first MIM capacitor MIM1 may be planarly overlapped with the first photodiode region PR1, the third photodiode region PR3, and the fourth photodiode region PR4. The fourth MIM capacitor MIM4 may include third and fourth metal films 345, 346 that overlap each other planarly in the third direction D3 and a portion of an interlayer insulating film 331 interposed between the third and fourth metal films 345, 346. The fourth MIM capacitor MIM4 may be planarly overlapped with the thirteenth photodiode region PR13.

The metal film of a MIM capacitor may include, but is not limited to, tungsten (W), aluminum (Al), copper (Cu), or combinations thereof. In some implementations, the material of the metal film of the MIM capacitor may be different from the material of the plurality of contacts 342 and the plurality of wires 341.

Although not illustrated, the wiring layer 330 may further include a bonding metal disposed at the top and having a portion of the bonding metal exposed by the interlayer insulating film 331, and the bonding metal may be bonded to a bonding metal of another laminated structure to form a bonding structure. In some implementations, the bonding structure may be formed by Cu-Cu bonding, but is not limited thereto.

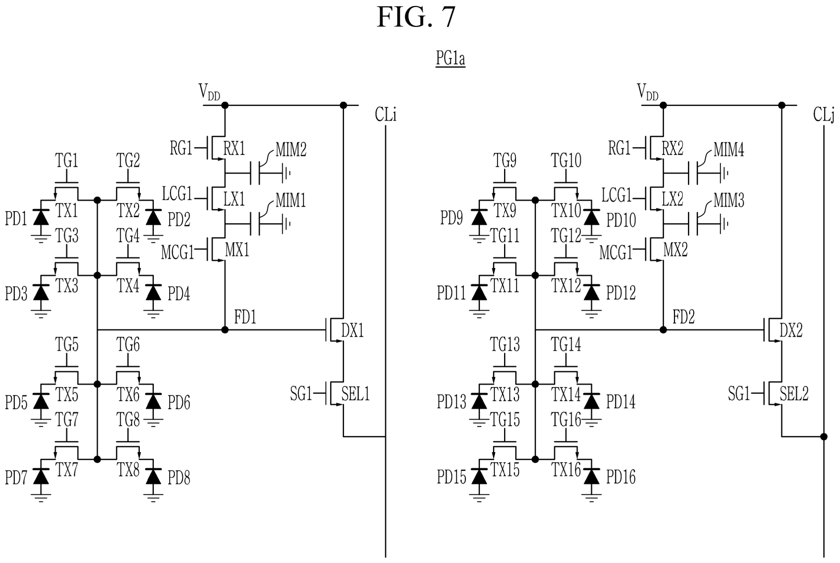

FIG. 7 is an example circuit diagram of a pixel group. Specifically, the circuit diagram of FIG. 7 illustrates the connection relationship between elements within the first pixel group PG1a of FIGs. 2 to 6. The first pixel group PG1a of FIG. 7 corresponds to the first pixel group PG1a of FIGS. 2 to 6, each of the first to sixteenth photodiodes PD1 to PD16 of FIG. 7 corresponds to the first to sixteenth photodiode regions PR1 to PR16 of FIGS. 2 to 6, respectively, and the first to fourth MIM capacitors MIM1 to MIM4 of FIG. 7 may correspond to the first to fourth MIM capacitors MIM1 to MIM4 of FIGS. 2 to 6, respectively.

Referring to FIGS. 2 to 7, the first pixel group PG1a may include first to sixteenth photodiodes PD1 to PD16, a first middle conversion gain transistor MX1, a first low conversion gain transistor LX1, a first reset transistor RX1, first and second MIM capacitors MIM1, MIM2, a first driving transistor DX1, a first select transistor SEL1, a second middle conversion gain transistor MX2, a second low conversion gain transistor LX2, a second reset transistor RX2, third and fourth MIM capacitors MIM3, MIM4, a second driving transistor DX2, and a second select transistor SEL2.

The first to eighth photodiodes PD1 to PD8 share the first floating diffusion node FD1 and may be electrically connected to the first floating diffusion node FD1. The ninth to sixteenth photodiodes PD9 to PD16 share the second floating diffusion node FD2 and may be electrically connected to the second floating diffusion node FD2. The first floating diffusion node FD1 and the second floating diffusion node FD2 may be separated from each other.

Each of the first to eighth photodiodes PD1 to PD8 may be electrically connected to a first floating diffusion node FD1 through each of the first to eighth transfer transistors TX1 to TX8. Each of the first to eighth transfer transistors TX1 to TX8 may provide photocharges generated from each of the first to eighth photodiodes PD1 to PD8 to the first floating diffusion node FD1 based on each of the first to eighth transfer signals TG1 to TG8.

Each of the ninth to sixteenth photodiodes PD9 to PD16 may be electrically connected to a second floating diffusion node FD2 through each of the ninth to sixteenth transfer transistors TX9 to TX16. Each of the ninth to sixteenth transfer transistors TX9 to TX16 may provide photocharges generated from each of the ninth to sixteenth photodiodes PD9 to PD16 to the second floating diffusion node FD2 based on each of the ninth to sixteenth transfer signals TG9 to TG16. In some implementations, the first through sixteenth transfer signals TG1 to TG16 may be provided from the row driver 120 of FIG. 1.

A first middle conversion gain transistor MX1, a first low conversion gain transistor LX1, and a first reset transistor RX1 may be connected in series between a first floating diffusion node FD1 and a power line providing a power voltage VDD.

A first middle conversion gain transistor MX1 may include a control terminal for receiving a first middle conversion gain enable signal MCG1, a first terminal electrically connected to one electrode of a first MIM capacitor MIM1, and a second terminal electrically connected to a first floating diffusion node FD1. In some implementations, the first middle conversion gain transistor MX1 may be an NMOS transistor. In the present disclosure, the first terminal may be referred to as a drain terminal and the second terminal may be referred to as a source terminal.

A first low conversion gain transistor LX1 may include a control terminal for receiving a first low conversion gain enable signal LCG1, a first terminal electrically connected to one electrode of a second MIM capacitor MIM2, and a second terminal electrically connected to one electrode of the first MIM capacitor MIM1. In some implementations, the first low conversion gain transistor LX1 may be an NMOS transistor.

The first reset transistor RX1 may include a control terminal for receiving a first reset signal RG1, a first terminal electrically connected to a power line providing a power voltage VDD, and a second terminal electrically connected to one electrode of a second MIM capacitor MIM2. In some implementations, the first reset transistor RX1 may be an NMOS transistor.

The first MIM capacitor MIM1 may include one electrode electrically connected to a first terminal of the first middle conversion gain transistor MX1 and a second terminal of the first low conversion gain transistor LX1, and the other electrode grounded. The second MIM capacitor MIM2 may include one electrode electrically connected to a first terminal of the first low conversion gain transistor LX1 and a second terminal of the first reset transistor RX1, and the other electrode grounded.

A second middle conversion gain transistor MX2, a second low conversion gain transistor LX2, and a second reset transistor RX2 may be connected in series between a second floating diffusion node FD2 and a power line providing a power voltage VDD.

A second middle conversion gain transistor MX2 may include a control terminal for receiving a first middle conversion gain enable signal MCG1, a first terminal electrically connected to one electrode of a third MIM capacitor MIM3, and a second terminal electrically connected to a second floating diffusion node FD2. In some implementations, the second middle conversion gain transistor MX2 may be an NMOS transistor.

The second low conversion gain transistor LX2 may include a control terminal for receiving a first low conversion gain enable signal LCG1, a first terminal electrically connected to one electrode of a fourth MIM capacitor MIM4, and a second terminal electrically connected to one electrode of a third MIM capacitor MIM3. In some implementations, the second low conversion gain transistor LX2 may be an NMOS transistor.

The second reset transistor RX2 may include a control terminal for receiving a first reset signal RG1, a first terminal electrically connected to a power line providing a power voltage VDD, and a second terminal electrically connected to one electrode of a fourth MIM capacitor MIM4. In some implementations, the second reset transistor RX2 may be an NMOS transistor.

The third MIM capacitor MIM3 may include one electrode electrically connected to a first terminal of the second middle conversion gain transistor MX2 and a second terminal of the second low conversion gain transistor LX2, and the other electrode grounded. The fourth MIM capacitor MIM4 may include one electrode electrically connected to a first terminal of the second low conversion gain transistor LX2 and a second terminal of the second reset transistor RX2, and the other electrode grounded.

In some implementations, the conversion gain mode for the first pixel group PG1a may be controlled by controlling the operation of the first middle conversion gain transistor MX1, the first low conversion gain transistor LX1, the second middle conversion gain transistor MX2, and the second low conversion gain transistor LX2.

In some implementations, in response to a turn-on operation of the first middle conversion gain transistor MX1, the first low conversion gain transistor LX1, and the first reset transistor RX1, charges stored in the first floating diffusion node FD1 and the first and second MIM capacitors MIM1, MIM2 may be reset. In some implementations, in response to the turn-on operation of the second middle conversion gain transistor MX2, the second low conversion gain transistor LX2, and the second reset transistor RX2, the charges stored in the second floating diffusion node FD2 and the third and fourth MIM capacitors MIM3, MIM4 may be reset.

The first driving transistor DX1 may include a control terminal electrically connected to the first floating diffusion node FD1, a first terminal electrically connected to a power line providing a power voltage VDD, and a second terminal electrically connected to a first terminal of the first select transistor SEL1. In some implementations, the first driving transistor DX1 may be an NMOS transistor.

The first select transistor SEL1 may include a control terminal for receiving a first select signal SG1, a first terminal electrically connected to a second terminal of the first driving transistor DX1, and a second terminal electrically connected to an i-th column line CLi. In some implementations, the first select transistor SEL1 may be an NMOS transistor.

The first driving transistor DX1 may amplify the photocharge in response to a potential according to the photocharge accumulated in the first floating diffusion node FD1 and transmit the pixel signal to the first select transistor SEL1. The first select transistor SEL1 may output a pixel signal to the i-th column line CLi electrically connected to the first to eighth photodiodes PD1 to PD8 in response to the first select signal SG1.

The second driving transistor DX2 may include a control terminal electrically connected to the second floating diffusion node FD2, a first terminal electrically connected to a power line providing a power voltage VDD, and a second terminal electrically connected to a first terminal of the second select transistor SEL2. In some implementations, the second driving transistor DX2 may be an NMOS transistor.

The second select transistor SEL2 may include a control terminal for receiving a first select signal SG1, a first terminal electrically connected to a second terminal of the second driving transistor DX2, and a second terminal electrically connected to a j-th column line CLj. In some implementations, the second select transistor SEL2 may be an NMOS transistor.

The second driving transistor DX2 may amplify the photocharge in response to a potential according to the photocharge accumulated in the second floating diffusion node FD2 and transmit the pixel signal to the second select transistor SEL2. The second select transistor SEL2 may output a pixel signal to the j-th column line CLj electrically connected to the ninth to sixteenth photodiodes PD9 to PD16 in response to the first select signal SG1.

In some implementations, the first middle conversion gain enable signal MCG1, the first low conversion gain enable signal LCG1, the first reset signal RG1, and the first select signal SG1 may be provided from the row driver 120 of FIG. 1.

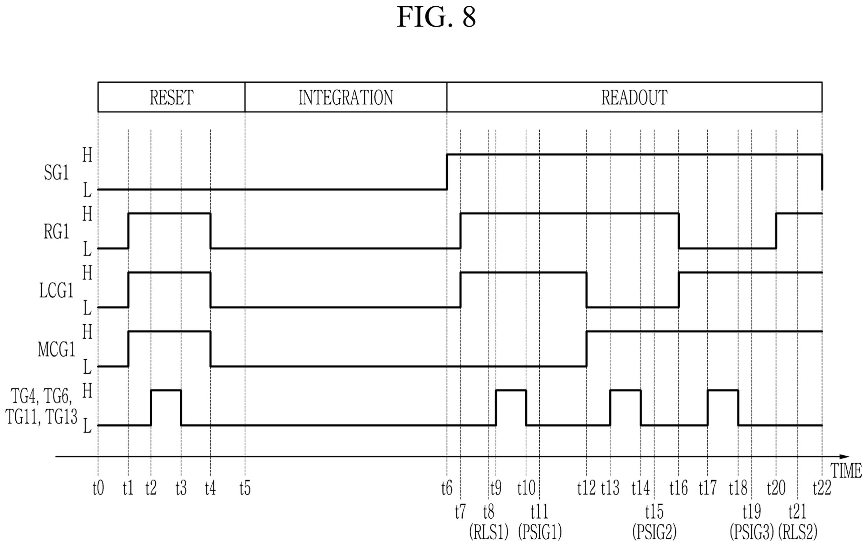

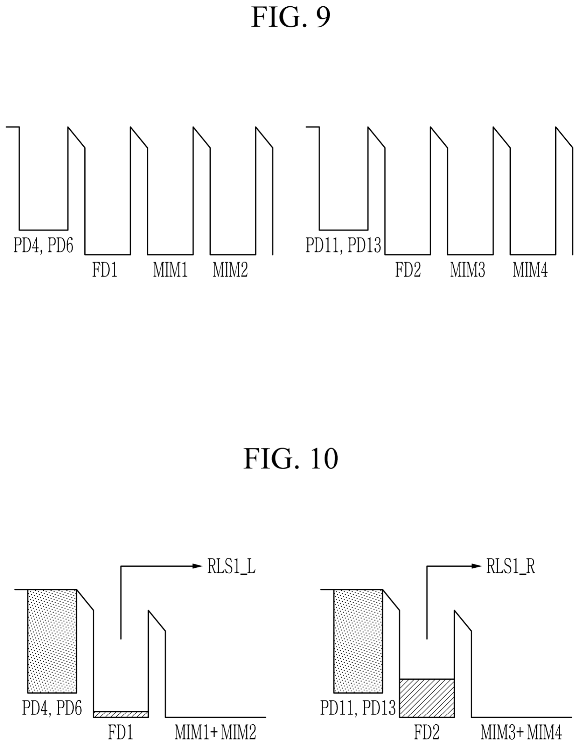

FIG. 8 is a timing diagram illustrating an example of AF operation of a pixel group. FIGS. 9, 10, 11, 12, 13, 14, 15, and 16 are drawings for explaining an example of AF operation of pixel groups. Specifically, FIGS. 9 to 16 each structurally illustrate the potential of a photodiode, a floating diffusion node, and a MIM capacitor in the AF operation of the first pixel group PG1a of FIG. 7.

Referring to FIGS. 3, 7, and 8, during the reset period between time t0 and time t5, a power voltage VDD may be provided to the photodiode, the floating diffusion node, and the MIM capacitor sharing the b-th micro lens MLb. During the reset period, charges present in the photodiode, floating diffusion node, and MIM capacitor may be reset by draining to the power line providing the supply voltage VDD.

At time t0, the first middle conversion gain enable signal MCG1, the first low conversion gain enable signal LCG1, the first reset signal RG1, the first select signal SG1, the fourth transfer signal TG4, the sixth transfer signal TG6, the eleventh transfer signal TG11, and the thirteenth transfer signal TG13 may be at a logic low level L. A first middle conversion gain transistor MX1, a first low conversion gain transistor LX1, a first reset transistor RX1, a first select transistor SEL1, a second middle conversion gain transistor MX2, a second low conversion gain transistor LX2, a second reset transistor RX2, a second select transistor SEL2, a fourth transfer transistor TX4, a sixth transfer transistor TX6, an eleventh transfer transistor TX11, and a thirteenth transfer transistor TX13 may be turned off.

At time t1, the first middle conversion gain enable signal MCG1, the first low conversion gain enable signal LCG1, and the first reset signal RG1 may transition from a logic low level L to a logic high level H. The first middle conversion gain transistor MX1, the first low conversion gain transistor LX1, the first reset transistor RX1, the second middle conversion gain transistor MX2, the second low conversion gain transistor LX2, and the second reset transistor RX2 may be turned on. Through the turn-on operation as described above, the power voltage VDD may be provided to the first floating diffusion node FD1 and the second floating diffusion node FD2.

At time t2, the fourth transfer signal TG4, the sixth transfer signal TG6, the eleventh transfer signal TG11, and the thirteenth transfer signal TG13 may transition from a logic low level L to a logic high level H. The fourth transfer transistor TX4, the sixth transfer transistor TX6, the eleventh transfer transistor TX11, and the thirteenth transfer transistor TX13 may be turned on. Through the turn-on operation as described above, the power voltage VDD may be provided to the fourth photodiode PD4, the sixth photodiode PD6, the eleventh photodiode PD11, and the thirteenth photodiode PD13.

At time t3, the fourth transfer signal TG4, the sixth transfer signal TG6, the eleventh transfer signal TG11, and the thirteenth transfer signal TG13 may transition from a logic high level H to a logic low level L. The fourth transfer transistor TX4, the sixth transfer transistor TX6, the eleventh transfer transistor TX11, and the thirteenth transfer transistor TX13 may be turned off.

At time t4, the first middle conversion gain enable signal MCG1, the first low conversion gain enable signal LCG1, and the first reset signal RG1 may transition from a logic high level H to a logic low level L. The first middle conversion gain transistor MX1, the first low conversion gain transistor LX1, the first reset transistor RX1, the second middle conversion gain transistor MX2, the second low conversion gain transistor LX2, and the second reset transistor RX2 may be turned off.

FIG. 9 shows the potential at time t5. With additional reference to FIG. 9, charges accumulated in the fourth photodiode PD4, the sixth photodiode PD6, the eleventh photodiode PD11, and the thirteenth photodiode PD13 within the first pixel group PG1a may be drained to a power line and reset. Additionally, charges stored in the first and second floating diffusion nodes FD1, FD2 and the first to fourth MIM capacitors MIM1 to MIM4 may be drained to the power line and reset.

During the integration period from time t5 to time t6, the fourth photodiode PD4, the sixth photodiode PD6, the eleventh photodiode PD11, and the thirteenth photodiode PD13 may be exposed to light and photoelectrically converted to generate photocharges. Photocharges generated by photoelectric conversion may be preferentially accumulated in photodiodes (PD4, PD6, PD11, PD13). In a high-light environment, charges accumulated in the photodiodes (PD4, PD6, PD11, PD13) from time t5 may overflow beyond the gate potential barrier of the turned-off transfer transistors (TX4, TX6, TX11, TX13). The overflowed charge may be transferred to and accumulated in the first and second floating diffusion nodes FD1, FD2 and the first to fourth MIM capacitors MIM1 to MIM4. Specifically, the overflowed charge may refer to a charge that is accumulated by moving to the first and second floating diffusion nodes FD1, FD2 and the first to fourth MIM capacitors MIM1 to MIM4 while the transfer transistors (TX4, TX6, TX11, TX13) are turned off when a certain amount of charge or more is charged in the photodiodes (PD4, PD6, PD11, PD13).

During the integration period, the first middle conversion gain enable signal MCG1 is at a logic low level L, the first middle conversion gain transistor MX1 and the second middle conversion gain transistor MX2 are turned off, so that the first floating diffusion node FD1 may be electrically isolated from the first and second MIM capacitors MIM1, MIM2, and the second floating diffusion node FD2 may be electrically isolated from the third and fourth MIM capacitors MIM3, MIM4. The first pixel group PG1a may operate in high conversion gain mode.

During the read-out period from time t6 to time t22, the pixel signal generated in the first pixel group PG1a is transmitted to the read-out circuit 130 of FIG. 1. During the read-out period, the first reset level signal RLS1, the first pixel signal PSIG1, the second pixel signal PSIG2, the third pixel signal PSIG3, and the second reset level signal RLS2 may be sequentially transmitted to the read-out circuit 130 of FIG. 1. In some implementations, a plurality of exposure operation may be performed in which the plurality of exposure operations are performed on the plurality of photodiodes within a first pixel group PG1a during a read-out period.

In some implementations, during the read-out period, the first pixel group PG1a may operate in a triple conversion gain mode, the first reset level signal RLS1 may be a reset level signal in a high conversion gain mode, the first pixel signal PSIG1 may be a pixel signal in a high conversion gain mode, the second pixel signal PSIG2 may be a pixel signal in a middle conversion gain mode, the third pixel signal PSIG3 may be a pixel signal in a low conversion gain mode, and the second reset level signal RLS2 may be a reset level signal in a low conversion gain mode.

At time t6, the first select signal SG1 may transition from a logic low level L to a logic high level H. The first select transistor SEL1 is turned on, and the second terminal of the first driving transistor DX1 and the i-th column line CLi may be electrically connected. The second select transistor SEL2 is turned on, and the second terminal of the second driving transistor DX2 and the j-th column line CLj may be electrically connected. Thereafter, the first select signal SG1 may be maintained at a logic high level H during the read-out period.

At time t7, the first low conversion gain enable signal LCG1 and the first reset signal RG1 may transition from a logic low level L to a logic high level H. A first low conversion gain transistor LX1, a second low conversion gain transistor LX2, a first reset transistor RX1, and a second reset transistor RX2 may be turned on. A power voltage VDD is provided to the first to fourth MIM capacitors MIM1 to MIM4, and the first to fourth MIM capacitors MIM1 to MIM4 may be reset.

At time t8, the first reset level signal RLS1 may be output. FIG. 10 shows the potential at time t8. With additional reference to FIG. 10, the first reset level signal RLS1 may include 1_1 and 1_2 reset level signals RLS1_L, RLS1_R, which are pixel signals generated by charges overflowing to first and second floating diffusion nodes FD1, FD2 that are separated from each other, respectively. Among the first reset level signals RLS1, the 1_1 reset level signal RLS1_L may be a pixel signal amplified by a voltage corresponding to the amount of charge charged in the first floating diffusion node FD1 connected to the fourth and sixth photodiodes PD4, PD6 located on the left. The 1_1 reset level signal RLS1_L may be provided to the read-out circuit 130 of FIG. 1 through the i-th column line CLi. Among the first reset level signals RLS1, the 1_2 reset level signal RLS1_R may be a pixel signal amplified by a voltage corresponding to the amount of charge charged in the second floating diffusion node FD2 connected to the eleventh and thirteenth photodiodes PD11, PD13 located on the right. The 1_2 reset level signal RLS1_R may be provided to the read-out circuit 130 of FIG. 1 through the j-th column line CLj.

At time t9, the fourth transfer signal TG4, the sixth transfer signal TG6, the eleventh transfer signal TG11, and the thirteenth transfer signal TG13 may transition from a logic low level L to a logic high level H. The fourth transfer transistor TX4, the sixth transfer transistor TX6, the eleventh transfer transistor TX11, and the thirteenth transfer transistor TX13 may be turned on. Through the turn-on operation as described above, the threshold voltage between the fourth and sixth photodiodes PD4, PD6 and the first floating diffusion node FD1 may be lowered, and the threshold voltage between the eleventh and thirteenth photodiodes PD11, PD13 and the second floating diffusion node FD2 may be lowered. Charges accumulated in the fourth and sixth photodiodes PD4, PD6 may move to the first floating diffusion node FD1 due to the potential difference, and charges accumulated in the eleventh and thirteenth photodiodes PD11, PD13 may move to the second floating diffusion node FD2 due to the potential difference.

At time t10, the fourth transfer signal TG4, the sixth transfer signal TG6, the eleventh transfer signal TG11, and the thirteenth transfer signal TG13 may transition from a logic high level H to a logic low level L. The fourth transfer transistor TX4, the sixth transfer transistor TX6, the eleventh transfer transistor TX11, and the thirteenth transfer transistor TX13 may be turned off.

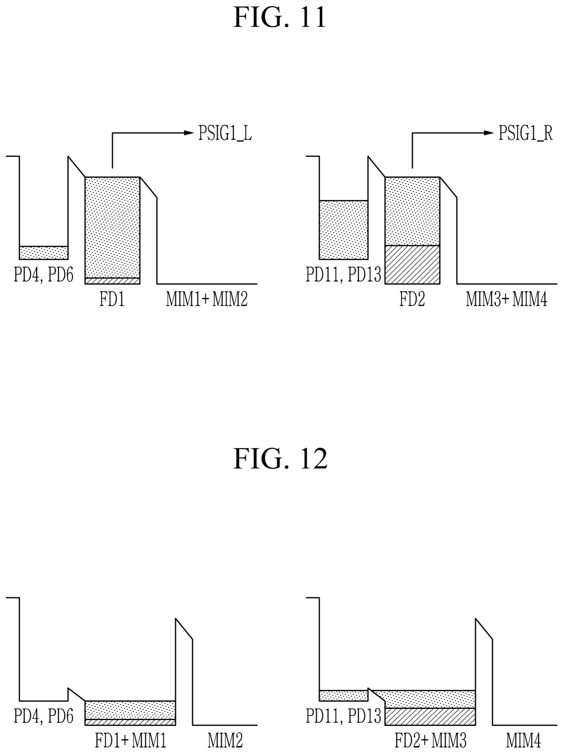

At time t11, the first pixel signal PSIG1 may be output. FIG. 11 shows the potential at time t11. With additional reference to FIG. 11, the first pixel signal PSIG1 may include 1_1 and 1_2 pixel signals PSIG1_L, PSIG1_R, which are pixel signals generated by charges accumulated in first and second floating diffusion nodes FD1, FD2 that are separated from each other. Among the first pixel signals PSIG1, the 1_1 pixel signal PSIG1_L may be a pixel signal amplified by a voltage corresponding to the amount of charge charged in the first floating diffusion node FD1 connected to the fourth and sixth photodiodes PD4, PD6 located on the left. The 1_1 pixel signal PSIG1_L may be provided to the read-out circuit 130 of FIG. 1 through the i-th column line CLi. Among the first pixel signals PSIG1, the 1_2 pixel signal PSIG1_R may be a pixel signal amplified by a voltage corresponding to the amount of charge charged in the second floating diffusion node FD2 connected to the eleventh and thirteenth photodiodes PD11, PD13 located on the right. The 1_2 pixel signal PSIG1_R may be provided to the read-out circuit 130 of FIG. 1 through the j-th column line CLj.

At time t12, the first middle conversion gain enable signal MCG1 may transition from a logic low level L to a logic high level H, and the first low conversion gain enable signal LCG1 may transition from a logic high level H to a logic low level L. The first middle conversion gain transistor MX1 and the second middle conversion gain transistor MX2 may be turned on, and the first low conversion gain transistor LX1 and the second low conversion gain transistor LX2 may be turned off. The first middle conversion gain transistor MX1 and the second middle conversion gain transistor MX2 are turned on so that the first floating diffusion node FD1 and the first MIM capacitor MIM1 may be electrically connected, and the second floating diffusion node FD2 and the third MIM capacitor MIM3 may be electrically connected. The first pixel group PG1a operates in a middle conversion gain mode and the capacitance for the first floating diffusion node FD1 and the second floating diffusion node FD2 may be increased.

At time t13, the fourth transfer signal TG4, the sixth transfer signal TG6, the eleventh transfer signal TG11, and the thirteenth transfer signal TG13 may transition from a logic low level L to a logic high level H. The fourth transfer transistor TX4, the sixth transfer transistor TX6, the eleventh transfer transistor TX11, and the thirteenth transfer transistor TX13 may be turned on.

FIG. 12 shows the potential at time t13. With additional reference to FIG. 12, through the turn-on operations of the fourth transfer transistor TX4, the sixth transfer transistor TX6, the eleventh transfer transistor TX11, and the thirteenth transfer transistor TX13 as described above, the threshold voltage between the fourth and sixth photodiodes PD4, PD6 and the first floating diffusion node FD1 may be lowered, and the threshold voltage between the eleventh and thirteenth photodiodes PD11, PD13 and the second floating diffusion node FD2 may be lowered. Charges accumulated in the fourth and sixth photodiodes PD4, PD6 may move to the first floating diffusion node FD1 and the first MIM capacitor MIM1 due to the potential difference, and charges accumulated in the eleventh and thirteenth photodiodes PD11, PD13 may move to the second floating diffusion node FD2 and the third MIM capacitor MIM3 due to the potential difference.

At time t14, the fourth transfer signal TG4, the sixth transfer signal TG6, the eleventh transfer signal TG11, and the thirteenth transfer signal TG13 may transition from a logic high level H to a logic low level L. The fourth transfer transistor TX4, the sixth transfer transistor TX6, the eleventh transfer transistor TX11, and the thirteenth transfer transistor TX13 may be turned off.

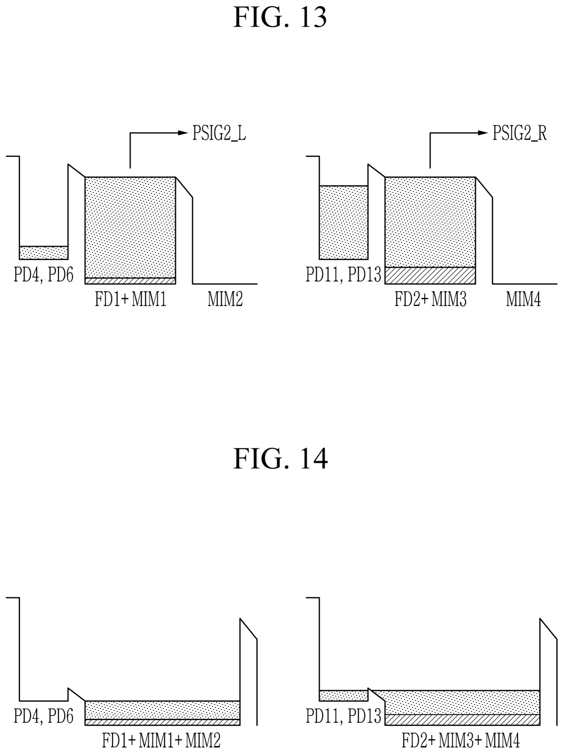

At time t15, a second pixel signal PSIG2 may be output. FIG. 13 shows the potential at time t15. With additional reference to FIG. 13, the second pixel signal PSIG2 may include 2_1 and 2_2 pixel signals PSIG2_L, PSIG2_R, which are pixel signals generated by charges accumulated in first and second floating diffusion nodes FD1, FD2 that are separated from each other. Among the second pixel signals PSIG2, the 2_1 pixel signal PSIG2_L may be a pixel signal amplified by a voltage corresponding to the amount of charge charged in the first floating diffusion node FD1 and the first MIM capacitor MIM1 connected to the fourth and sixth photodiodes PD4, PD6 located on the left. The 2_1 pixel signal PSIG2_L may be provided to the read-out circuit 130 of FIG. 1 through the i-th column line CLi. Among the second pixel signals PSIG2, the 2_2 pixel signal PSIG2_R may be a pixel signal amplified by a voltage corresponding to the amount of charge charged in the second floating diffusion node FD2 and the third MIM capacitor MIM3 connected to the eleventh and thirteenth photodiodes PD11, PD13 located on the right. The 2_2 pixel signal PSIG2_R may be provided to the read-out circuit 130 of FIG. 1 through the j-th column line CLj.

At time t16, the first low conversion gain enable signal LCG1 may transition from a logic low level L to a logic high level H, and the first reset signal RG1 may transition from a logic high level H to a logic low level L. The first low conversion gain transistor LX1 and the second low conversion gain transistor LX2 may be turned on, and the first reset transistor RX1 and the second reset transistor RX2 may be turned off. The first low conversion gain transistor LX1 and the second low conversion gain transistor LX2 are turned on so that the first floating diffusion node FD1 and the first and second MIM capacitors MIM1, MIM2 may be electrically connected, and the second floating diffusion node FD2 and the third and fourth MIM capacitors MIM3, MIM4 may be electrically connected. The first pixel group PG1a operates in low conversion gain mode and the capacitance for the first floating diffusion node FD1 and the second floating diffusion node FD2 may be increased.

At time t17, the fourth transfer signal TG4, the sixth transfer signal TG6, the eleventh transfer signal TG11, and the thirteenth transfer signal TG13 may transition from a logic low level L to a logic high level H. The fourth transfer transistor TX4, the sixth transfer transistor TX6, the eleventh transfer transistor TX11, and the thirteenth transfer transistor TX13 may be turned on.

FIG. 14 shows the potential at time t17. With additional reference to FIG. 14, through the turn-on operations of the fourth transfer transistor TX4, the sixth transfer transistor TX6, the eleventh transfer transistor TX11, and the thirteenth transfer transistor TX13 as described above, the threshold voltage between the fourth and sixth photodiodes PD4, PD6 and the first floating diffusion node FD1 may be lowered, and the threshold voltage between the eleventh and thirteenth photodiodes PD11, PD13 and the second floating diffusion node FD2 may be lowered. Charges accumulated in the fourth and sixth photodiodes PD4, PD6 may move to the first floating diffusion node FD1 and the first and second MIM capacitors MIM1, MIM2 due to the potential difference, and charges accumulated in the eleventh and thirteenth photodiodes PD11, PD13 may move to the second floating diffusion node FD2 and the third and fourth MIM capacitors MIM3, MIM4 due to the potential difference.

At time t18, the fourth transfer signal TG4, the sixth transfer signal TG6, the eleventh transfer signal TG11, and the thirteenth transfer signal TG13 may transition from a logic high level H to a logic low level L. The fourth transfer transistor TX4, the sixth transfer transistor TX6, the eleventh transfer transistor TX11, and the thirteenth transfer transistor TX13 may be turned off.

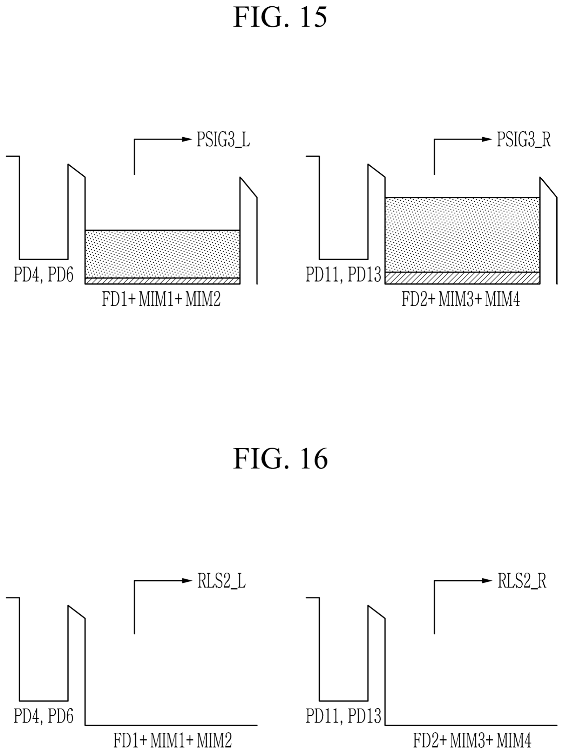

At time t19, the third pixel signal PSIG3 may be output. FIG. 15 shows the potential at time t19. With additional reference to FIG. 15, the third pixel signal PSIG3 may include 3_1 and 3_2 pixel signals PSIG3_L, PSIG3_R, which are pixel signals generated by charges accumulated in the first and second floating diffusion nodes FD1, FD2 which are separated from each other. Among the third pixel signals PSIG3, the 3_1 pixel signal PSIG3_L may be a pixel signal amplified by a voltage corresponding to the amount of charge charged in the first floating diffusion node FD1 and the first and second MIM capacitors MIM1, MIM2 connected to the fourth and sixth photodiodes PD4, PD6 located on the left. The 3_1 pixel signal PSIG3_L may be provided to the read-out circuit 130 of FIG. 1 through the i-th column line CLi. Among the third pixel signals PSIG3, the 3_2 pixel signal PSIG3_R may be a pixel signal amplified by a voltage corresponding to the amount of charge charged in the second floating diffusion node FD2 and the third and fourth MIM capacitors MIM3, MIM4 connected to the eleventh and thirteenth photodiodes PD11, PD13 located on the right. The 3_2 pixel signal PSIG3_R may be provided to the read-out circuit 130 of FIG. 1 through the j-th column line CLj.

At time t20, the first reset signal RG1 may transition from a logic low level L to a logic high level H. The first reset transistor RX1 and the second reset transistor RX2 may be turned on. Through the turn-on operation as described above, the power voltage VDD may be provided to the fourth photodiode PD4, the sixth photodiode PD6, the eleventh photodiode PD11, the thirteenth photodiode PD13, the first and second floating diffusion nodes FD1, FD2, and the first to fourth MIM capacitors MIM1 to MIM4. Charges present in the fourth photodiode PD4, the sixth photodiode PD6, the eleventh photodiode PD11, the thirteenth photodiode PD13, the first and second floating diffusion nodes FD1, FD2, and the first to fourth MIM capacitors MIM1 to MIM4 may be reset by being drained to a power line providing a power voltage VDD.

At time t21, a second reset level signal RLS2 may be output. FIG. 16 shows the potential at time t21. With additional reference to FIG. 16, the second reset level signal RLS2 may include 2_1 and 2_2 reset level signals RLS2_L, RLS2_R, which are pixel signals generated by charges remaining in each of the first and second floating diffusion nodes FD1, FD2 that are separated from each other. Among the second reset level signals RLS2, the 2_1 reset level signal RLS2_L may be a pixel signal amplified by a voltage corresponding to the amount of charge remaining in the first floating diffusion node FD1 and the first and second MIM capacitors MIM1, MIM2 connected to the fourth and sixth photodiodes PD4, PD6 located on the left. The 2_1 reset level signal RLS2_L may be provided to the read-out circuit 130 of FIG. 1 through the -th column line CLi. Among the second reset level signals RLS2, the 2_2 reset level signal RLS2_R may be a pixel signal amplified by a voltage corresponding to the amount of charge remaining in the second floating diffusion node FD2 and the third and fourth MIM capacitors MIM3, MIM4 connected to the eleventh and thirteenth photodiodes PD11, PD13 located on the right. The 2_2 reset level signal RLS2_R may be provided to the read-out circuit 130 of FIG. 1 through the j-th column line CLj.

At time t22, the first select signal SG1 may transition from a logic high level H to a logic low level L. The first select transistor SEL1 and the second select transistor SEL2 are turned off, and the read-out period may be terminated.

A first pixel group PG1a may include at least two photodiodes connected to separate shared floating diffusion nodes and sharing one of the b-th micro lens MLb. By arranging at least two photodiodes within the first pixel group PG1a as described above, the image sensor may have both high-resolution image quality and accurate AF performance. Thereby, pixels may be arranged without a metal layer and/ or that perform only phase detection operation. In addition, through the arrangement of at least two photodiodes within the first pixel group PG1a as described above, the image sensor may easily perform AF operation by receiving left and right pixel signals together without receiving pixel signals in the order of a reset level signal, a left pixel signal, and a left and right summed pixel signal in an RSS (Reset-Signal-Signal) manner.

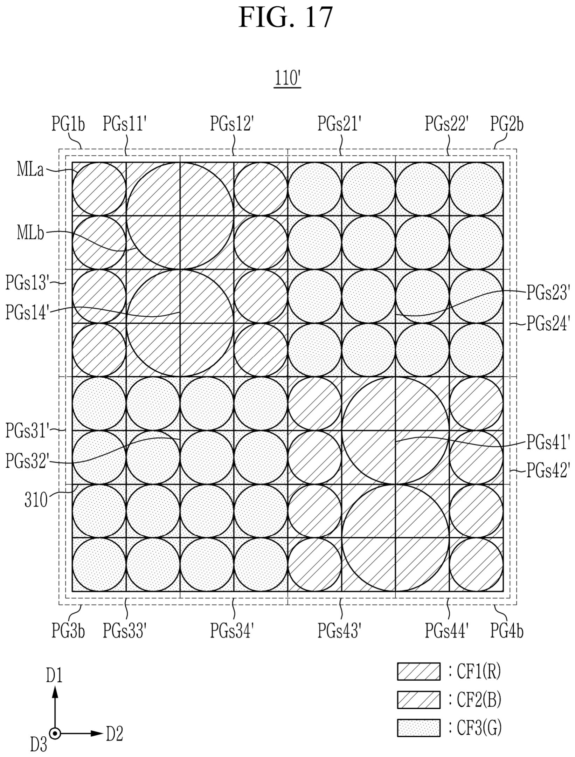

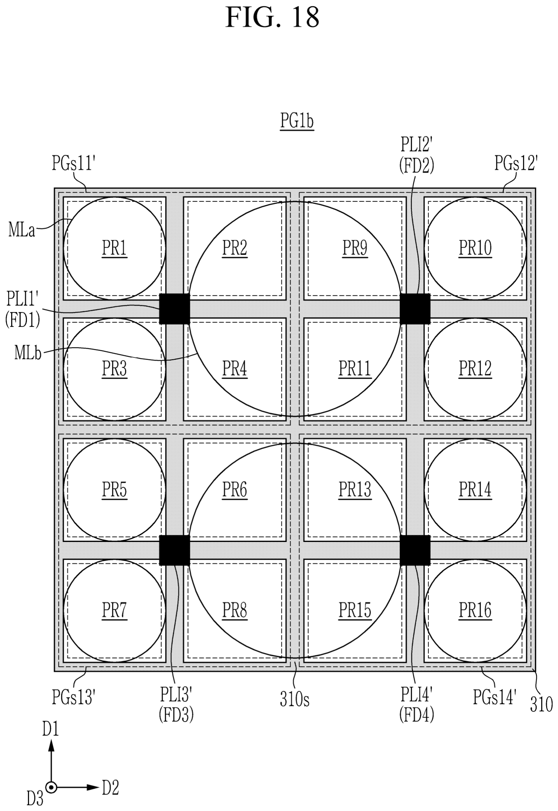

FIG. 17 is a plan view illustrating an example of a pixel array. FIG. 18 is an example enlarged view of the first pixel group of the pixel array of FIG. 17. The pixel array 110' and the first to fourth pixel groups PG1b to PG4b of FIGS. 17 and 18 may each correspond to the pixel array 110 and the first to fourth pixel groups PG1a to PG4a of FIGS. 2 and 3, respectively. For ease of explanation below, the pixel array 110' and the first to fourth pixel groups PG1b to PG4b will be described with a focus on differences from the pixel array 110 and the first to fourth pixel groups PG1a to PG4a of FIGS. 2 and 3.

Referring to FIG. 1 of FIG. 17, and FIG. 18, the pixel array 110' may include first to fourth pixel groups PG1b to PG4b. Each of the first to fourth pixel groups PG1b to PG4b may include four sub-pixel groups arranged in the first direction D1 and the second direction D2, and each sub-pixel group may share a floating diffusion node, a reset transistor, a conversion gain transistor, a MIM capacitor, and a driving transistor. The image sensor 100 may be miniaturized and provide high-resolution images through a shared structure of each sub-pixel group.

The first pixel group PG1b may include 1_1 to 1_4 sub-pixel groups PGs11' to PGs14' arranged in a 2x2 array in the first direction D1 and the second direction D2, and the second pixel group PG2b may include 2_1 to 2_4 sub-pixel groups PGs21' to PGs24' arranged in a 2x2 array in the first direction D1 and the second direction D2. Similarly, the third pixel group PG3b may include 1_1 to 1_4 sub-pixel groups PGs11' to PGs14' arranged 2×2 in the first direction D1 and the second direction D2, and the fourth pixel group PG4b may include 4_1 to 4_4 sub-pixel groups PGs41' to PGs44' arranged 2×2 in the first direction D1 and the second direction D2.

Below, for ease of explanation, the sub-pixel groups will be described with a focus on the 1_1 to 1_4 sub-pixel groups PGs11' to PGs14'. The description of the 1_1 to 1_4 sub-pixel groups PGs11' to PGs14' below may be applied to other sub-pixel groups within the pixel array 110'.

The 1_1 to 1_4 sub-pixel groups PGs11' to PGs14' may be separated by a pixel group separation region 310s extending in the first direction D1 and the second direction D2. The pixel group separation region 310s is a portion of the device isolation pattern 310, and the 1_1 to 1_4 sub-pixel groups PGs11' to PGs14' may be separated in the first direction D1 and the second direction D2 by the pixel group separation region 310s.

The 1_1 sub-pixel group PGs11' may include first to fourth photodiode regions PR1 to PR4 arranged 2×2 in the first direction D1 and the second direction D2, and the 1_2 sub-pixel group PGs12' may include fifth to eighth photodiode regions PR5 to PR8 arranged 2×2 in the first direction D1 and the second direction D2. The 1_3 sub-pixel group PGs13' may include ninth to twelfth photodiode regions PR9 to PR12 arranged 2×2 in the first direction D1 and the second direction D2, and the 1_4 sub-pixel group PGs14' may include thirteenth to sixteenth photodiode regions PR13 to PR16 arranged 2×2 in the first direction D1 and the second direction D2.

The first to fourth photodiode regions PR1 to PR4 share a first floating diffusion node FD1, and the photodiodes of the first to fourth photodiode regions PR1 to PR4 may be electrically connected to the first floating diffusion node FD1. The ninth to twelfth photodiode regions PR9 to PR12 share a second floating diffusion node FD2, and the photodiodes of the ninth to twelfth photodiode regions PR9 to PR12 may be electrically connected to the second floating diffusion node FD2. The fifth to eighth photodiode regions PR5 to PR8 share a third floating diffusion node FD3, and the photodiodes of the fifth to eighth photodiode regions PR5 to PR8 may be electrically connected to the third floating diffusion node FD3. The thirteenth to sixteenth photodiode regions PR13 to PR16 share a fourth floating diffusion node FD4, and the photodiodes of the thirteenth to sixteenth photodiode regions PR13 to PR16 may be electrically connected to the fourth floating diffusion node FD4. The first to fourth floating diffusion nodes FD1 to FD4 may be electrically isolated from each other.

The first floating diffusion node FD1 may include a first poly local interconnect PLI1'. At least a portion of the first poly local interconnect PLI1' may be planarly overlapped with the first to fourth photodiode regions PR1 to PR4. The second floating diffusion node FD2 may include a second poly local interconnect PLI2'. At least a portion of the second poly local interconnect PLI2' may be planarly overlapped with the ninth to twelfth photodiode regions PR9 to PR12. The third floating diffusion node FD3 may include a third poly local interconnect PLI3'. At least a portion of the third poly local interconnect PLI3' may be planarly overlapped with the fifth to eighth photodiode regions PR5 to PR8. The fourth floating diffusion node FD4 may include a fourth poly local interconnect PLI4'. At least a portion of the fourth poly local interconnect PLI4' may be planarly overlapped with the thirteenth to sixteenth photodiode regions PR13 to PR16.

The first to fourth poly local interconnects PLI1' to PLI4' include a conductive pattern, wherein the conductive pattern may include at least one of doped polysilicon, a metal, a metal silicide, a metal nitride, or a metal-containing film. For example, the second poly local interconnect PLI2' may be made of polysilicon doped with an N-type impurity, such as phosphorus (P) or arsenic (As).

Additionally, a pixel group separation region 310s may be placed between the first to fourth poly local interconnects PLI1' to PLI4'.

Although not illustrated, an insulating spacer may be positioned along the sidewall of each of the first to fourth poly local interconnects PLI1' to PLI4'.

The a-th micro lens MLa may be positioned on the first photodiode region PR1 and the third photodiode region PR3 of the 1_1 sub-pixel group PGs11', respectively. Each of the first photodiode region PR1 and the third photodiode region PR3 may correspond to the a-th micro lens MLa. The a-th micro lens MLa may be positioned on the tenth photodiode region PR10 and the twelfth photodiode region PR12 among the 1_2 sub-pixel group PGs12', respectively. Each of the tenth photodiode region PR10 and the twelfth photodiode region PR12 may correspond to the a-th micro lens MLa. The a-th micro lens MLa may be positioned on the fifth photodiode region PR5 and the seventh photodiode region PR7 among the 1_3 sub-pixel groups PGs13', respectively. Each of the fifth photodiode region PR5 and the seventh photodiode region PR7 may correspond to one of the a-th micro lens MLa. The a-th micro lens MLa may be positioned on the fourteenth photodiode region PR14 and the sixteenth photodiode region PR16 among the 1_4 sub-pixel groups PGs14', respectively. Each of the fourteenth photodiode region PR14 and the sixteenth photodiode region PR16 may correspond to one of the a-th micro lens MLa.

The read-out circuit 130 may receive a pixel signal for a photodiode corresponding to the a-th micro lens MLa and generate image data IDTA of FIG. 1.

The b-th micro lens MLb may be arranged across the 1_1 sub-pixel group PGs11' and the 1_2 sub-pixel group PGs12', and may be arranged on the second photodiode region PR2, the fourth photodiode region PR4, the ninth photodiode region PR9, and the eleventh photodiode region PR11. The second photodiode region PR2, the fourth photodiode region PR4, the ninth photodiode region PR9, and the eleventh photodiode region PR11 may share the b-th micro lens MLb. Additionally, the b-th micro lens MLb may be arranged across the 1_3 sub-pixel group PGs13' and the 1_4 sub-pixel group PGs14', and may be arranged on the sixth photodiode region PR6, the eighth photodiode region PR8, the thirteenth photodiode region PR13, and the fifteenth photodiode region PR15. The sixth photodiode region PR6, the eighth photodiode region PR8, the thirteenth photodiode region PR13, and the fifteenth photodiode region PR15 may share the b-th micro lens MLb.

The read-out circuit 130 may receive a pixel signal for a photodiode corresponding to the micro lens MLb and generate image data IDTA or phase data PDTA. The read-out circuit 130 may receive pixel signals corresponding to photodiodes of the second photodiode region PR2 and the fourth photodiode region PR4 located on the left among the second photodiode region PR2, the fourth photodiode region PR4, the ninth photodiode region PR9, and the eleventh photodiode region PR11 to extract first phase information, and may receive pixel signals corresponding to photodiodes of the ninth photodiode region PR9 and the eleventh photodiode region PR11 located on the right to extract second phase information. Similarly, the read-out circuit 130 may receive pixel signals corresponding to photodiodes of the sixth photodiode region PR6 and the eighth photodiode region PR8 located on the left among the sixth photodiode region PR6, the eighth photodiode region PR8, the thirteenth photodiode region PR13, and the fifteenth photodiode region PR15 to extract first phase information, and may receive pixel signals corresponding to photodiodes of the thirteenth photodiode region PR13 and the fifteenth photodiode region PR15 located on the right to extract second phase information.

The read-out circuit 130 may generate phase data PDTA by comparing the first phase information and the second phase information. The read-out circuit 130 may substantially simultaneously receive pixel signals for photodiodes of the second photodiode region PR2, the fourth photodiode region PR4, the sixth photodiode region PR6, the eighth photodiode region PR8, the ninth photodiode region PR9, the eleventh photodiode region PR11, the thirteenth photodiode region PR13, and the fifteenth photodiode region PR15 through a separation structure for the first to fourth floating diffusion nodes FD1 to FD4.

Additionally, the read-out circuit 130 may generate image data IDTA based on pixel signals for photodiodes of the second photodiode region PR2, the fourth photodiode region PR4, the sixth photodiode region PR6, the eighth photodiode region PR8, the ninth photodiode region PR9, the eleventh photodiode region PR11, the thirteenth photodiode region PR13, and the fifteenth photodiode region PR15.

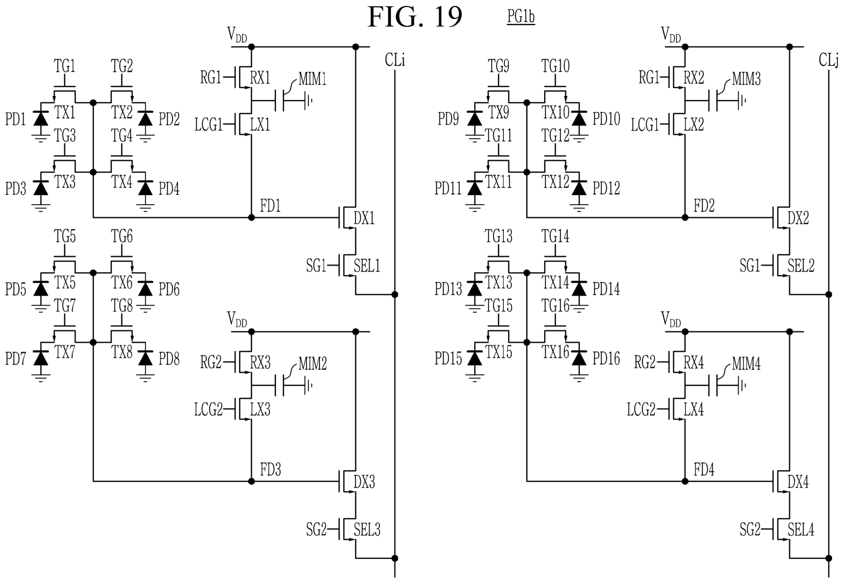

FIG. 19 is an example circuit diagram of a pixel group. Specifically, the circuit diagram of FIG. 19 illustrates the connection relationship between elements within the first pixel group PG1b of FIGs. 17 and 18. The first pixel group PG1b of FIG. 19 may correspond to the first pixel group PG1b of FIGS. 17 to 18, the first to sixteenth photodiodes PD1 to PD16 of FIG. 19 may correspond to the first to sixteenth photodiode regions PR1 to PR16 of FIGS. 17 to 18, respectively, and the first to fourth MIM capacitors MIM1 to MIM4 of FIG. 19 may correspond to the first to fourth MIM capacitors MIM1 to MIM4 of FIGS. 2 to 6, respectively.

Referring to FIGS. 17 to 19, the first pixel group PG1b may include first to sixteenth photodiodes PD1 to PD16, first to fourth low conversion gain transistors LX1 to LX4, first to fourth reset transistors RX1 to RX4, first to fourth MIM capacitors MIM1 to MIM4, first to fourth driving transistors DX1 to DX4, and first to fourth select transistors SEL1 to SEL4.

The first to fourth photodiodes PD1 to PD4 share the first floating diffusion node FD1 and may be electrically connected to the first floating diffusion node FD1. The ninth to twelfth photodiodes PD9 to PD12 share the second floating diffusion node FD2 and may be electrically connected to the second floating diffusion node FD2. The fifth to eighth photodiodes PD5 to PD8 share the third floating diffusion node FD3 and may be electrically connected to the third floating diffusion node FD3. The thirteenth to sixteenth photodiodes PD13 to PD16 share the fourth floating diffusion node FD4 and may be electrically connected to the fourth floating diffusion node FD4. The first to fourth floating diffusion nodes FD1 to FD4 may be separated from each other.

Each of the first to fourth photodiodes PD1 to PD4 may be electrically connected to the first floating diffusion node FD1 through each of the first to fourth transfer transistors TX1 to TX4. Each of the first to fourth transfer transistors TX1 to TX4 may provide photocharges generated from each of the first to fourth photodiodes PD1 to PD4 to the first floating diffusion node FD1 based on each of the first to fourth transfer signals TG1 to TG4.

Each of the ninth to twelfth photodiodes PD9 to PD12 may be electrically connected to a second floating diffusion node FD2 through each of the ninth to twelfth transfer transistors TX9 to TX12. Each of the ninth to twelfth transfer transistors TX9 to TX12 may provide photocharges generated from each of the ninth to twelfth photodiodes PD9 to PD12 to the second floating diffusion node FD2 based on each of the ninth to twelfth transfer signals TG9 to TG12.

Each of the fifth to eighth photodiodes PD5 to PD8 may be electrically connected to a third floating diffusion node FD3 through each of the fifth to eighth transfer transistors TX5 to TX8. Each of the fifth to eighth transfer transistors TX5 to TX8 may provide photocharges generated from each of the fifth to eighth photodiodes PD5 to PD8 to the third floating diffusion node FD3 based on each of the fifth to eighth transfer signals TG5 to TG8.

Each of the thirteenth to sixteenth photodiodes PD13 to PD16 may be electrically connected to the fourth floating diffusion node FD4 through each of the thirteenth to sixteenth transfer transistors TX13 to TX16. Each of the thirteenth to sixteenth transfer transistors TX13 to TX16 may provide photocharges generated from each of the thirteenth to sixteenth photodiodes PD13 to PD16 to the fourth floating diffusion node FD4 based on each of the thirteenth to sixteenth transfer signals TG13 to TG16.

A first low conversion gain transistor LX1 may include a control terminal receiving a first low conversion gain enable signal LCG1, a first terminal electrically connected to one electrode of a first MIM capacitor MIM1, and a second terminal electrically connected to a first floating diffusion node FD1. In some implementations, the first low conversion gain transistor LX1 may be an NMOS transistor.

The first reset transistor RX1 may include a control terminal for receiving a first reset signal RG1, a first terminal electrically connected to a power line providing a power voltage VDD, and a second terminal electrically connected to one electrode of a first MIM capacitor MIM1. In some implementations, the first reset transistor RX1 may be an NMOS transistor.

The first MIM capacitor MIM1 may include one electrode electrically connected to a first terminal of the first low conversion gain transistor LX1 and a second terminal of the first reset transistor RX1, and the other electrode grounded.

A second low conversion gain transistor LX2 may include a control terminal receiving a first low conversion gain enable signal LCG1, a first terminal electrically connected to one electrode of a third MIM capacitor MIM3, and a second terminal electrically connected to a second floating diffusion node FD2. In some implementations, the second low conversion gain transistor LX2 may be an NMOS transistor.

The second reset transistor RX2 may include a control terminal for receiving a first reset signal RG1, a first terminal electrically connected to a power line providing a power voltage VDD, and a second terminal electrically connected to one electrode of a third MIM capacitor MIM3. In some implementations, the second reset transistor RX2 may be an NMOS transistor.

The third MIM capacitor MIM3 may include one electrode electrically connected to a first terminal of the second low conversion gain transistor LX2 and a second terminal of the second reset transistor RX2, and the other electrode grounded.

A third low conversion gain transistor LX3 may include a control terminal receiving a second low conversion gain enable signal LCG2, a first terminal electrically connected to one electrode of a second MIM capacitor MIM2, and a second terminal electrically connected to a third floating diffusion node FD3. In some implementations, the third low conversion gain transistor LX3 may be an NMOS transistor.

The third reset transistor RX3 may include a control terminal for receiving a second reset signal RG2, a first terminal electrically connected to a power line providing a power voltage VDD, and a second terminal electrically connected to one electrode of a second MIM capacitor MIM2. In some implementations, the third reset transistor RX3 may be an NMOS transistor.

The second MIM capacitor MIM2 may include one electrode electrically connected to a first terminal of the third low conversion gain transistor LX3 and a second terminal of the third reset transistor RX3, and the other electrode grounded.

A fourth low conversion gain transistor LX4 may include a control terminal receiving a second low conversion gain enable signal LCG2, a first terminal electrically connected to one electrode of a fourth MIM capacitor MIM4, and a second terminal electrically connected to a fourth floating diffusion node FD4. In some implementations, the fourth low conversion gain transistor LX4 may be an NMOS transistor.

The fourth reset transistor RX4 may include a control terminal for receiving a second reset signal RG2, a first terminal electrically connected to a power line providing a power voltage VDD, and a second terminal electrically connected to one electrode of a fourth MIM capacitor MIM4. In some implementations, the fourth reset transistor RX4 may be an NMOS transistor.

The fourth MIM capacitor MIM4 may include one electrode electrically connected to a first terminal of the fourth low conversion gain transistor LX4 and a second terminal of the fourth reset transistor RX4, and the other electrode grounded.

In some implementations, the conversion gain mode for the first pixel group PG1b may be controlled by controlling the operation of the first to fourth row conversion gain transistors LX1 to LX4.

In some implementations, in response to a turn-on operation of the first low conversion gain transistor LX1 and the first reset transistor RX1, charges stored in the first floating diffusion node FD1 and the first MIM capacitor MIM1 may be reset. In some implementations, in response to the turn-on operation of the second low conversion gain transistor LX2 and the second reset transistor RX2, the charge stored in the second floating diffusion node FD2 and the third MIM capacitor MIM3 may be reset. In some implementations, in response to the turn-on operation of the third low conversion gain transistor LX3 and the third reset transistor RX3, the charge stored in the third floating diffusion node FD3 and the second MIM capacitor MIM2 may be reset. In some implementations, in response to the turn-on operation of the fourth low conversion gain transistor LX4 and the fourth reset transistor RX4, the charge stored in the fourth floating diffusion node FD4 and the fourth MIM capacitor MIM4 may be reset.

The first driving transistor DX1 may include a control terminal electrically connected to the first floating diffusion node FD1, a first terminal electrically connected to a power line providing a power voltage VDD, and a second terminal electrically connected to a first terminal of the first select transistor SEL1. In some implementations, the first driving transistor DX1 may be an NMOS transistor.

The first select transistor SEL1 may include a control terminal for receiving a first select signal SG1, a first terminal electrically connected to a second terminal of the first driving transistor DX1, and a second terminal electrically connected to an i-th column line CLi. In some implementations, the first select transistor SEL1 may be an NMOS transistor.

The first driving transistor DX1 may amplify the photocharge and transfer it to the first select transistor SEL1 in response to a potential according to the photocharge accumulated in the first floating diffusion node FD1. The first select transistor SEL1 may output a pixel signal to the i-th column line CLi electrically connected to the first to fourth photodiodes PD1 to PD4 in response to the first select signal SG1.

The second driving transistor DX2 may include a control terminal electrically connected to the second floating diffusion node FD2, a first terminal electrically connected to a power line providing a power voltage VDD, and a second terminal electrically connected to a first terminal of the second select transistor SEL2. In some implementations, the second driving transistor DX2 may be an NMOS transistor.

The second select transistor SEL2 may include a control terminal for receiving a first select signal SG1, a first terminal electrically connected to a second terminal of the second driving transistor DX2, and a second terminal electrically connected to a j-th column line CLj. In some implementations, the second select transistor SEL2 may be an NMOS transistor.

The second driving transistor DX2 may amplify the photocharge and transfer it to the second select transistor SEL2 in response to a potential according to the photocharge accumulated in the second floating diffusion node FD2. The second select transistor SEL2 may output a pixel signal to the j-th column line CLj electrically connected to the ninth to twelfth photodiodes PD9 to PD12 in response to the first select signal SG1.

The third driving transistor DX3 may include a control terminal electrically connected to the third floating diffusion node FD3, a first terminal electrically connected to a power line providing a power voltage VDD, and a second terminal electrically connected to a first terminal of the third select transistor SEL3. In some implementations, the third driving transistor DX3 may be an NMOS transistor.

The third select transistor SEL3 may include a control terminal for receiving a second select signal SG2, a first terminal electrically connected to a second terminal of the third driving transistor DX3, and a second terminal electrically connected to an i-th column line CLi. In some implementations, the third select transistor SEL3 may be an NMOS transistor.

The third driving transistor DX3 may amplify the photocharge and transfer it to the third select transistor SEL3 in response to a potential according to the photocharge accumulated in the third floating diffusion node FD3. The third select transistor SEL3 may output a pixel signal to the i-th column line CLi electrically connected to the fifth to eighth photodiodes PD5 to PD8 in response to the second select signal SG2.

The fourth driving transistor DX4 may include a control terminal electrically connected to the fourth floating diffusion node FD4, a first terminal electrically connected to a power line providing a power voltage VDD, and a second terminal electrically connected to a first terminal of the fourth select transistor SEL4. In some implementations, the fourth driving transistor DX4 may be an NMOS transistor.

The fourth select transistor SEL4 may include a control terminal for receiving a second select signal SG2, a first terminal electrically connected to a second terminal of the second driving transistor DX2, and a second terminal electrically connected to a j-th column line CLj. In some implementations, the fourth select transistor SEL4 may be an NMOS transistor.

The fourth driving transistor DX4 may amplify the photocharge and transfer it to the fourth select transistor SEL4 in response to a potential according to the photocharge accumulated in the fourth floating diffusion node FD4. The fourth select transistor SEL4 may output a pixel signal to the j-th column line CLj electrically connected to the thirteenth to sixteenth photodiodes PD13 to PD16 in response to the second select signal SG2.

In some implementations, the first and second row conversion gain enable signals LCG1, LCG2, the first and second reset signals RG1, RG2, and the first and second select signals SG1, SG2 may be provided from the row driver 120 of FIG. 1.

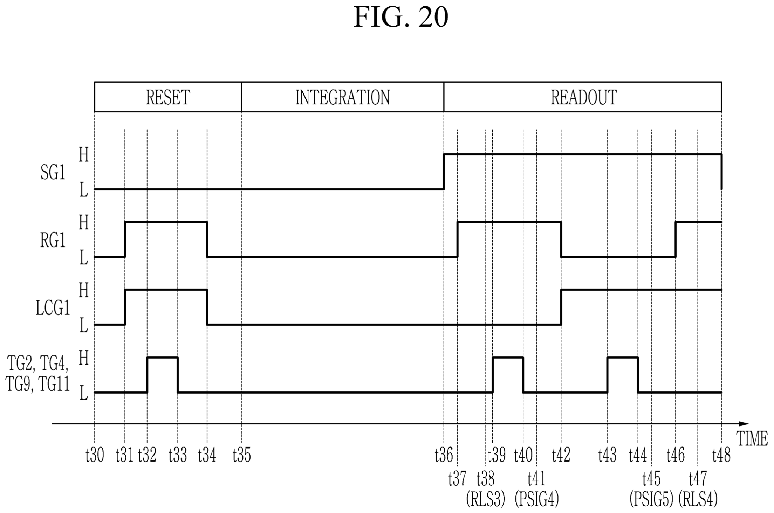

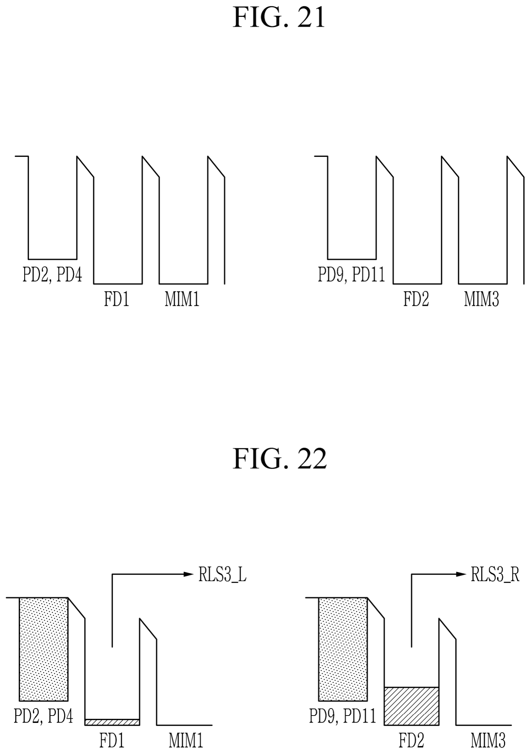

FIG. 20 is a timing diagram illustrating an example of AF operation of a pixel group. FIGS. 21, 22, 23, 24, 25, and 26 are drawings for explaining an example of AF operation of pixel groups. Specifically, FIGS. 21 to 26 each structurally illustrate the potentials of the photodiode, the floating diffusion node, and the MIM capacitor in the AF operation of the first pixel group PG1b of FIG. 19. For ease of explanation below, the AF operation for the 1_1 sub-pixel group PGs11' and the 1_2 sub-pixel group PGs12' of FIG. 18 will be mainly described.

Referring to FIGS. 18 to 20, during the reset period between time points t30 and t35, a power voltage VDD may be provided to the photodiode, the floating diffusion node, and the MIM capacitor sharing the b-th micro lens MLb. During the reset period, charges present in the photodiode, floating diffusion node, and MIM capacitor may be reset by draining to the power line providing the supply voltage VDD.

At time t30, the first low conversion gain enable signal LCG1, the first reset signal RG1, the first select signal SG1, the second transfer signal TG2, the fourth transfer signal TG4, the ninth transfer signal TG9, and the eleventh transfer signal TG11 may be at a logic low level L. The first low conversion gain transistor LX1, the first reset transistor RX1, the first select transistor SEL1, the second low conversion gain transistor LX2, the second reset transistor RX2, the second select transistor SEL2, the second transfer transistor TX2, the fourth transfer transistor TX4, the ninth transfer transistor TX9, and the eleventh transfer transistor TX11 may be turned off.

At time t31, the first low conversion gain enable signal LCG1 and the first reset signal RG1 may transition from a logic low level L to a logic high level H. The first low conversion gain transistor LX1, the first reset transistor RX1, the second low conversion gain transistor LX2, and the second reset transistor RX2 may be turned on. Through the turn-on operation as described above, the power voltage VDD may be provided to the first floating diffusion node FD1 and the second floating diffusion node FD2.

At time t32, the second transfer signal TG2, the fourth transfer signal TG4, the ninth transfer signal TG9, and the eleventh transfer signal TG11 may transition from a logic low level L to a logic high level H. The second transfer transistor TX2, the fourth transfer transistor TX4, the ninth transfer transistor TX9, and the eleventh transfer transistor TX11 may be turned on. Through the turn-on operation as described above, the power voltage VDD may be provided to the second photodiode PD2, the fourth photodiode PD4, the ninth photodiode PD9, and the eleventh photodiode PD11.

At time t33, the second transfer signal TG2, the fourth transfer signal TG4, the ninth transfer signal TG9, and the eleventh transfer signal TG11 may transition from a logic high level H to a logic low level L. The second transfer transistor TX2, the fourth transfer transistor TX4, the ninth transfer transistor TX9, and the eleventh transfer transistor TX11 may be turned off.

At time t34, the first low conversion gain enable signal LCG1 and the first reset signal RG1 may transition from a logic high level H to a logic low level L. The first low conversion gain transistor LX1, the first reset transistor RX1, the second low conversion gain transistor LX2, and the second reset transistor RX2 may be turned off.

FIG. 21 shows the potential at time t35. Referring additionally to FIG. 21, charges accumulated in the second photodiode PD2, the fourth photodiode PD4, the ninth photodiode PD9, and the eleventh photodiode PD11 within the first pixel group PG1b may be drained to a power line and reset. Additionally, charges accumulated in the first and second floating diffusion nodes FD1, FD2 and the first and third MIM capacitors MIM1, MIM3 may be drained to the power line and reset.

During the integration period from time point t35 to time point t36, the second photodiode PD2, the fourth photodiode PD4, the ninth photodiode PD9, and the eleventh photodiode PD11 may be exposed to light and photoelectrically converted to generate photocharges. Photocharges generated by photoelectric conversion may be preferentially accumulated in photodiodes (PD2, PD4, PD9, PD11). In a high-light environment, from time t35, charges accumulated in the photodiodes (PD2, PD4, PD9, PD11) may overflow beyond the gate potential barrier of the turned-off transfer transistors (TX2, TX4, TX9, TX11) and move to and accumulate in the first and second floating diffusion nodes FD1, FD2 and the first and third MIM capacitors MIM1, MIM3.

During the integration period, the first low conversion gain enable signal LCG1 is at a logic low level L, the first low conversion gain transistor LX1 and the second low conversion gain transistor LX2 are turned off, so that the first floating diffusion node FD1 may be electrically isolated from the first MIM capacitor MIM1 and the second floating diffusion node FD2 may be electrically isolated from the third MIM capacitor MIM3. The first pixel group PG1b may operate in high conversion gain mode.

During the read-out period from time point t36 to time point t48, the pixel signal generated in the first pixel group PG1b is transmitted to the read-out circuit 130 of FIG. 1. During the read-out period, the third reset level signal RLS3, the fourth pixel signal PSIG4, the fifth pixel signal PSIG5, and the fourth reset level signal RLS4 may be sequentially transmitted to the read-out circuit 130 of FIG. 1. In some implementations, a plurality of exposure operation may be performed in which the plurality of exposure operations are performed on the photodiodes within the first pixel group PG1b during the read-out period.

In some implementations, during the read-out period, the first pixel group PG1b may operate in a dual conversion gain mode, the third reset level signal RLS3 may be a reset level signal in a high conversion gain mode, the fourth pixel signal PSIG4 may be a pixel signal in a high conversion gain mode, the fifth pixel signal PSIG5 may be a pixel signal in a low conversion gain mode, and the fourth reset level signal RLS4 may be a reset level signal in the low conversion gain mode.

At time t36, the first select signal SG1 may transition from a logic low level L to a logic high level H. The first select signal SG1 may transition from a logic low level L to a logic high level H. The first select transistor SEL1 is turned on, and the second terminal of the first driving transistor DX1 and the i-th column line CLi may be electrically connected. The second select transistor SEL2 is turned on, and the second terminal of the second driving transistor DX2 and the j-th column line CLj may be electrically connected. Thereafter, the first select signal SG1 may be maintained at a logic high level H during the read-out period.

At time t37, the first reset signal RG1 may transition from a logic low level L to a logic high level H. The first reset transistor RX1 and the second reset transistor RX2 may be turned on. A power voltage VDD is provided to the first and third MIM capacitors MIM1, MIM3, and the first and third MIM capacitors MIM1, MIM3 may be reset.

At time t38, the third reset level signal RLS3 may be output. FIG. 22 shows the potential at time t38. With additional reference to FIG. 22, the third reset level signal RLS3 may include 3_1 and 3_2 reset level signals RLS3_L, RLS3_R, which are pixel signals generated by charges overflowing to the first and second floating diffusion nodes FD1, FD2 which are separated from each other. Among the third reset level signals RLS3, the 3_1 reset level signal RLS3_L may be a pixel signal amplified by a voltage corresponding to the amount of charge charged in the first floating diffusion node FD1 connected to the second and fourth photodiodes PD2, PD4 located on the left. The 3_1 reset level signal RLS3_L may be provided to the read-out circuit 130 of FIG. 1 through the i-th column line CLi. Among the third reset level signals RLS3, the 3_2 reset level signal RLS3_R may be a pixel signal amplified by a voltage corresponding to the amount of charge charged in the second floating diffusion node FD2 connected to the ninth and eleventh photodiodes PD9, PD11 located on the right. The 3_2 reset level signal RLS3_R may be provided to the read-out circuit 130 of FIG. 1 through the j-th column line CLj.

At time t39, the second transfer signal TG2, the fourth transfer signal TG4, the ninth transfer signal TG9, and the eleventh transfer signal TG11 may transition from a logic low level L to a logic high level H. The second transfer transistor TX2, the fourth transfer transistor TX4, the ninth transfer transistor TX9, and the eleventh transfer transistor TX11 may be turned on. Through the turn-on operation as described above, the threshold voltage between the second and fourth photodiodes PD2, PD4 and the first floating diffusion node FD1 may be lowered, and the threshold voltage between the ninth and eleventh photodiodes PD9, PD11 and the second floating diffusion node FD2 may be lowered. Charges accumulated in the second and fourth photodiodes PD2, PD4 may move to the first floating diffusion node FD1 due to the potential difference, and charges accumulated in the ninth and eleventh photodiodes PD9, PD11 may move to the second floating diffusion node FD2 due to the potential difference.

At time t40, the second transfer signal TG2, the fourth transfer signal TG4, the ninth transfer signal TG9, and the eleventh transfer signal TG11 may transition from a logic high level H to a logic low level L. The second transfer transistor TX2, the fourth transfer transistor TX4, the ninth transfer transistor TX9, and the eleventh transfer transistor TX11 may be turned off.

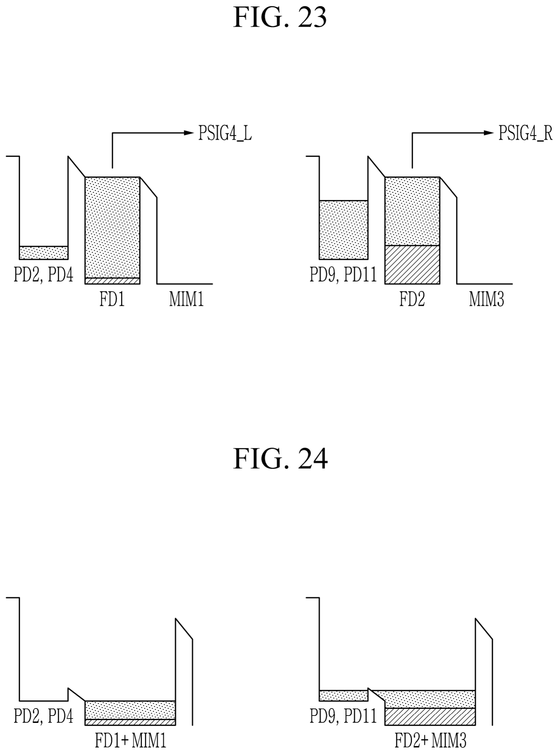

At time t41, the fourth pixel signal PSIG4 may be output. FIG. 23 shows the potential at time t41. With additional reference to FIG. 23, the fourth pixel signal PSIG4 may include 4_1 and 4_2 pixel signals PSIG4_L, PSIG4_R, which are pixel signals generated by charges accumulated in the first and second floating diffusion nodes FD1, FD2 which are separated from each other. Among the fourth pixel signals PSIG4, the 4_1 pixel signal PSIG4_L may be a pixel signal amplified by a voltage corresponding to the amount of charge charged in the first floating diffusion node FD1 connected to the second and fourth photodiodes PD2, PD4 located on the left. The 4_1 pixel signal PSIG4_L may be provided to the read-out circuit 130 of FIG. 1 through the i-th column line CLi. Among the fourth pixel signals PSIG4, the 4_2 pixel signal PSIG4_R may be a pixel signal amplified by a voltage corresponding to the amount of charge charged in the second floating diffusion node FD2 connected to the ninth and eleventh photodiodes PD9, PD11 located on the right. The 4_2 pixel signal PSIG4_R may be provided to the read-out circuit 130 of FIG. 1 through the j-th column line CLj.

At time t42, the first low conversion gain enable signal LCG1 may transition from a logic low level L to a logic high level H, and the first reset signal RG1 may transition from a logic high level H to a logic low level L. The first low conversion gain transistor LX1 and the second low conversion gain transistor LX2 may be turned on. A first low conversion gain transistor LX1 and a second low conversion gain transistor LX2 are turned on so that a first floating diffusion node FD1 and a first MIM capacitor MIM1 may be electrically connected, and a second floating diffusion node FD2 and a third MIM capacitor MIM3 may be electrically connected. The first pixel group PG1b operates in low conversion gain mode and the capacitance for the first floating diffusion node FD1 and the second floating diffusion node FD2 may be increased.

At time t43, the second transfer signal TG2, the fourth transfer signal TG4, the ninth transfer signal TG9, and the eleventh transfer signal TG11 may transition from a logic low level L to a logic high level H. The second transfer transistor TX2, the fourth transfer transistor TX4, the ninth transfer transistor TX9, and the eleventh transfer transistor TX11 may be turned on.

FIG. 24 shows the potential at time t43. With additional reference to FIG. 24, through the turn-on operations of the second transfer transistor TX2, the fourth transfer transistor TX4, the ninth transfer transistor TX9, and the eleventh transfer transistor TX11 as described above, the threshold voltage between the second and fourth photodiodes PD2, PD4 and the first floating diffusion node FD1 may be lowered, and the threshold voltage between the ninth and eleventh photodiodes PD9, PD11 and the second floating diffusion node FD2 may be lowered. Charges accumulated in the second and fourth photodiodes PD2, PD4 may move to the first floating diffusion node FD1 and the first MIM capacitor MIM1 due to the potential difference, and charges accumulated in the ninth and eleventh photodiodes PD9, PD11 may move to the second floating diffusion node FD2 and the third MIM capacitor MIM3 due to the potential difference.

At time t44, the second transfer signal TG2, the fourth transfer signal TG4, the ninth transfer signal TG9, and the eleventh transfer signal TG11 may transition from a logic high level H to a logic low level L. The second transfer transistor TX2, the fourth transfer transistor TX4, the ninth transfer transistor TX9, and the eleventh transfer transistor TX11 may be turned off.

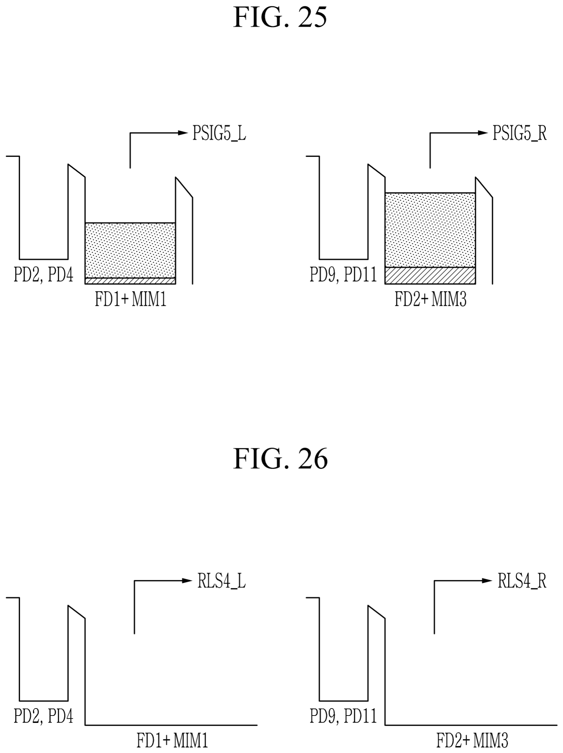

At time t45, the fifth pixel signal PSIG5 may be output. FIG. 25 shows the potential at time t45. With additional reference to FIG. 25, the fifth pixel signal PSIG5 may include 5_1 and 5_2 pixel signals PSIG5_L, PSIG5_R, which are pixel signals generated by charges accumulated in the first and second floating diffusion nodes FD1, FD2 which are separated from each other. Among the fifth pixel signals PSIG5, the 5_1 pixel signal PSIG5_L may be a pixel signal amplified by a voltage corresponding to the amount of charge charged in the first floating diffusion node FD1 and the first MIM capacitor MIM1 connected to the second and fourth photodiodes PD2, PD4 located on the left. The 5_1 pixel signal PSIG5_L may be provided to the read-out circuit 130 of FIG. 1 through the i-th column line CLi. Among the fifth pixel signals PSIG5, the 5_2 pixel signal PSIG5_R may be a pixel signal amplified by a voltage corresponding to the amount of charge charged in the second floating diffusion node FD2 and the third MIM capacitor MIM3 connected to the ninth and eleventh photodiodes PD9, PD11 located on the right. The 5_2 pixel signal PSIG5_R may be provided to the read-out circuit 130 of FIG. 1 through the j-th column line CLj.

At time t46, the first reset signal RG1 may transition from a logic low level L to a logic high level H. The first reset transistor RX1 and the second reset transistor RX2 may be turned on. Through the turn-on operation as described above, the power voltage VDD may be provided to the second photodiode PD2, the fourth photodiode PD4, the ninth photodiode PD9, the eleventh photodiode PD11, the first and second floating diffusion nodes FD1, FD2, and the first and third MIM capacitors MIM1, MIM3. Charges present in the second photodiode PD2, the fourth photodiode PD4, the ninth photodiode PD9, the eleventh photodiode PD11, the first and second floating diffusion nodes FD1, FD2, and the first and third MIM capacitors MIM1, MIM3 may be reset by being drained to a power line providing a power voltage VDD.

At time t47, the fourth reset level signal RLS4 may be output. FIG. 26 shows the potential at time t47. With additional reference to FIG. 26, the fourth reset level signal RLS4 may include 4_1 and 4_2 reset level signals RLS4_L, RLS4_R, which are pixel signals generated by charges remaining in each of the first and second floating diffusion nodes FD1, FD2 that are separated from each other. Among the fourth reset level signals RLS4, the 4_1 reset level signal RLS4_L may be a pixel signal amplified by a voltage corresponding to the amount of charge remaining in the first floating diffusion node FD1 and the first MIM capacitor MIM1 connected to the second and fourth photodiodes PD2, PD4 located on the left. The 4_1 reset level signal RLS4_L may be provided to the read-out circuit 130 of FIG. 1 through the i-th column line CLi. Among the fourth reset level signals RLS4, the 4_2 reset level signal RLS4_R may be a pixel signal amplified by a voltage corresponding to the amount of charge remaining in the second floating diffusion node FD2 and the third MIM capacitor MIM3 connected to the ninth and eleventh photodiodes PD9, PD11 located on the right. The 4_2 reset level signal RLS4_R may be provided to the read-out circuit 130 of FIG. 1 through the j-th column line CLj.

At time t48, the first select signal SG1 may transition from a logic high level H to a logic low level L. The first select transistor SEL1 and the second select transistor SEL2 are turned off, and the read-out period may be terminated.

A first pixel group PG1b may include at least two photodiodes connected to separate shared floating diffusion nodes and sharing one of the b-th micro lens MLb. By arranging at least two photodiodes within the first pixel group PG1b as described above, the image sensor may have both high-resolution image quality and accurate AF performance by not arranging pixels that include a metal layer and perform only phase detection operation. In addition, through the arrangement of at least two photodiodes within the first pixel group PG1b as described above, the image sensor may easily perform AF operation by receiving left and right pixel signals together without performing the RSS method.

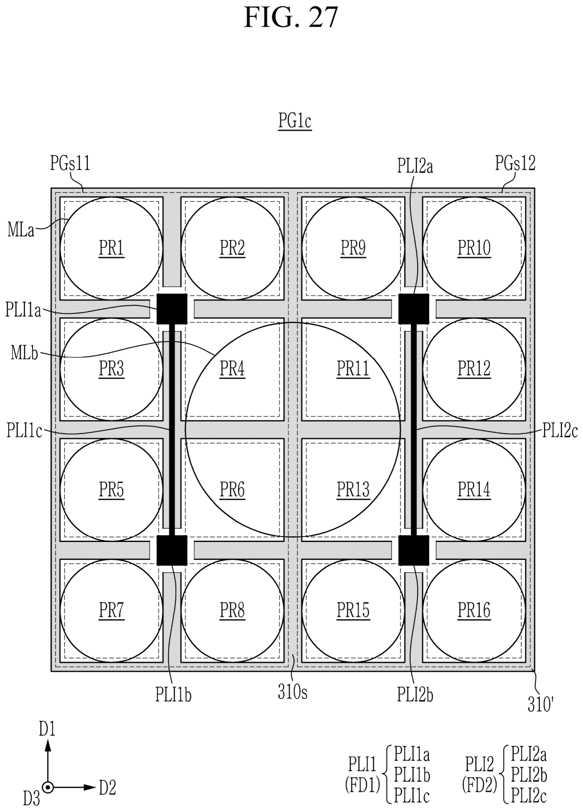

FIG. 27 is a plan view illustrating examples of pixel groups. Each of the first pixel group PG1c, the first and second poly local interconnects PLI1, PLI2, and the device isolation pattern 310' of FIG. 27 may correspond to the first pixel group PG1a, the first and second poly local interconnects PLI1, PLI2, and the device isolation pattern 310 of FIG. 3, respectively. For ease of explanation below, the first pixel group PG1c, the first and second poly local interconnects PLI1, PLI2, and the device isolation pattern 310' will be described with a focus on differences from the first pixel group PG1a, the first and second poly local interconnects PLI1, PLI2, and the device isolation pattern 310 of FIG. 3.

Referring to FIG. 27, the first to sixteenth photodiode regions PR1 to PR16 included in the first pixel group PG1c may be electrically separated by a device isolation pattern 310'.

In some implementations, the device isolation pattern 310' is arranged in a deformed mesh shape within the semiconductor substrate, and a plurality of photodiode regions may be divided and electrically isolated according to the deformed mesh shape. The device isolation pattern 310' may be disposed on a portion of a boundary between the first to fourth photodiode regions PR1 to PR4, a portion of a boundary between the fifth to eighth photodiode regions PR5 to PR8, a portion of a boundary between the ninth to twelfth photodiode regions PR9 to PR12, and a portion of a boundary between the thirteenth to sixteenth photodiode regions PR13 to PR16. The device isolation pattern 310' may be planarly non-overlapping with the first_a contact region PLI1a and the first_b contact region PLI1b of the first poly local interconnect PLI1 and the second_a contact region PLI2a and the second_b contact region PLI2b of the second poly local interconnect PLI2.

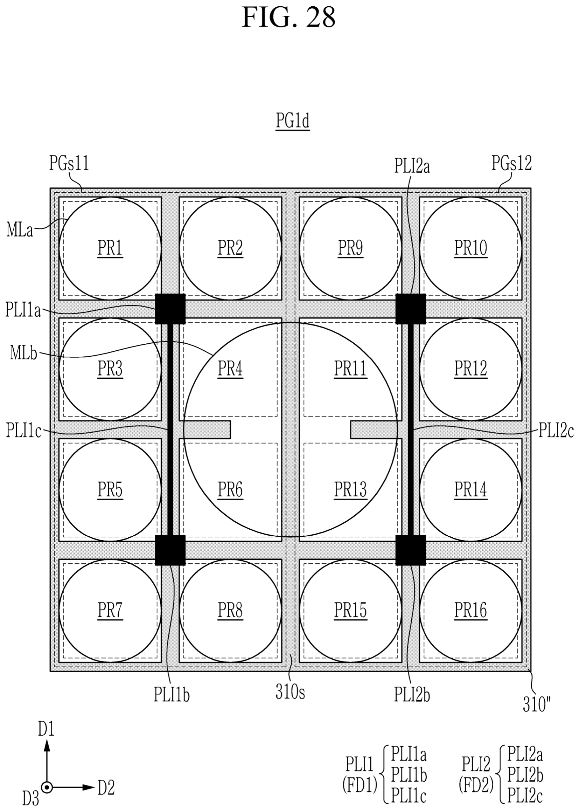

FIG. 28 is a plan view illustrating examples of pixel groups. Each of the first pixel group PG1d and the device isolation pattern 310" of FIG. 28 may correspond to each of the first pixel group PG1a and the device isolation pattern 310 of FIG. 3. For ease of explanation below, the first pixel group PG1d and the device isolation pattern 310" will be described with a focus on differences from the first pixel group PG1a and the device isolation pattern 310 of FIG. 3.

Referring to FIG. 28, the first to sixteenth photodiode regions PR1 to PR16 included in the first pixel group PG1d may be electrically separated by a device isolation pattern 310".

In some implementations, the device isolation pattern 310" is arranged in a deformed mesh shape within the semiconductor substrate, and a plurality of photodiode regions may be divided and electrically isolated according to the deformed mesh shape. The device isolation pattern 310" may be located at a portion of the boundary between photodiode regions of the same sub-pixel group sharing one of the b-th micro lens MLb.

Referring to FIG. 28 as an example, the device isolation pattern 310" may be disposed on a portion of the boundary between the fourth photodiode region PR4 and the sixth photodiode region PR6 of the first sub-pixel group PGs11 disposed below the b-th micro lens MLb. Similarly, the device isolation pattern 310" may be disposed on a portion of the boundary between the eleventh photodiode region PR11 and the thirteenth photodiode region PR13 of the 1_2 sub-pixel group PGs12 disposed below the b-th micro lens MLb.

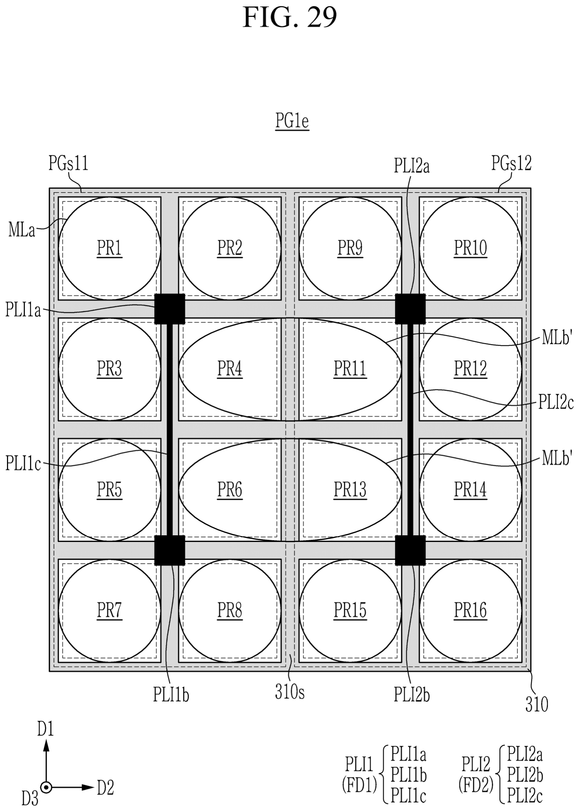

FIG. 29 is a plan view illustrating examples of pixel groups. Each of the first pixel group PG1e, the a-th micro lens MLa, and the b-th micro lens MLb' of FIG. 29 may correspond to the first pixel group PG1a, the a-th micro lens MLa, and the b-th micro lens MLb of FIG. 3, respectively. For ease of explanation below, the first pixel group PG1e, the a-th micro lens MLa, and the b-th micro lens MLb' will be described with a focus on differences from the first pixel group PG1a, the a-th micro lens MLa, and the b-th micro lens MLb of FIG. 3.

The a-th micro lens MLa corresponds to one photodiode and is capable of planarly overlapping at least a portion of the corresponding photodiode with respect to a third direction D3 and focusing incident light onto the corresponding photodiode. An image sensor may generate image data IDTA of FIG. 1 through photodiodes corresponding to the a-th micro lens MLa. A photodiode corresponding to the a-th micro lens MLa may be used for image generation purposes. The b-th micro lens MLb' corresponds to the photodiodes arranged in a 1×2 array, and at least a portion of the lens is planarly overlapped with the corresponding photodiodes and may focus incident light onto the corresponding photodiodes. The photodiodes arranged 1×2 among the first pixel group PG1e may share the b micro-lens MLb', and the image sensor may generate the image data IDTA and the phase data PDTA of FIG. 1 through a plurality of photodiodes sharing the b micro-lens MLb'. Multiple photodiodes sharing the b-th micro lens MLb' may be used for image generation and phase detection purposes.

The a-th micro lens MLa may be positioned on the first photodiode region PR1, the second photodiode region PR2, the third photodiode region PR3, the fifth photodiode region PR5, the seventh photodiode region PR7, and the eighth photodiode region PR8 among the 1_1 sub-pixel group PGs11. Each of the first photodiode region PR1, the second photodiode region PR2, the third photodiode region PR3, the fifth photodiode region PR5, the seventh photodiode region PR7, and the eighth photodiode region PR8 may correspond to one of the a-th micro lens MLa.

The a-th micro lens MLa may be arranged on the ninth photodiode region PR9, the tenth photodiode region PR10, the twelfth photodiode region PR12, the fourteenth photodiode region PR14, the fifteenth photodiode region PR15, and the sixteenth photodiode region PR16 among the 1_2 sub-pixel groups PGs12, respectively. Each of the ninth photodiode region PR9, the tenth photodiode region PR10, the twelfth photodiode region PR12, the fourteenth photodiode region PR14, the fifteenth photodiode region PR15, and the sixteenth photodiode region PR16 may correspond to one of the a-th micro lens MLa.

The read-out circuit 130 of FIG. 1 may receive a pixel signal for a photodiode corresponding to the a-th micro lens MLa and generate image data IDTA of FIG. 1.

The b-th micro lens MLb' may be arranged across the 1_1 sub-pixel group PGs11 and the 1_2 sub-pixel group PGs12. Referring to FIG. 29 as an example, one micro lens MLb' of the b type may be placed on the fourth photodiode region PR4 and the eleventh photodiode region PR11. Additionally, one of the b-th micro lens MLb' may be placed on the sixth photodiode region PR6 and the thirteenth photodiode region PR13. The fourth photodiode region PR4 and the eleventh photodiode region PR11 may share one of the b-th micro lens MLb', and the sixth photodiode region PR6 and the thirteenth photodiode region PR13 may share one of the b-th micro lens MLb'.

The read-out circuit 130 of FIG. 1 may receive a pixel signal for a photodiode corresponding to the b-th micro lens MLb' and generate image data IDTAor phase data PDTA of FIG. 1. The read-out circuit 130 receives pixel signals corresponding to the photodiodes of the fourth photodiode region PR4 and the sixth photodiode region PR6 located on the left among the fourth photodiode region PR4, the sixth photodiode region PR6, the eleventh photodiode region PR11, and the thirteenth photodiode region PR13 to extract first phase information, and receives pixel signals corresponding to the photodiodes of the eleventh photodiode region PR11 and the thirteenth photodiode region PR13 located on the right to extract second phase information. The read-out circuit 130 may generate phase data PDTA by comparing the first phase information and the second phase information. The read-out circuit 130 may substantially simultaneously receive pixel signals for photodiodes of the fourth photodiode region PR4, the sixth photodiode region PR6, the eleventh photodiode region PR11, and the thirteenth photodiode region PR13 through a separation structure for the first and second floating diffusion nodes FD1, FD2.

Additionally, the read-out circuit 130 of FIG. 1 may generate image data IDTA based on pixel signals for photodiodes of the fourth photodiode region PR4, the sixth photodiode region PR6, the eleventh photodiode region PR11, and the thirteenth photodiode region PR13.

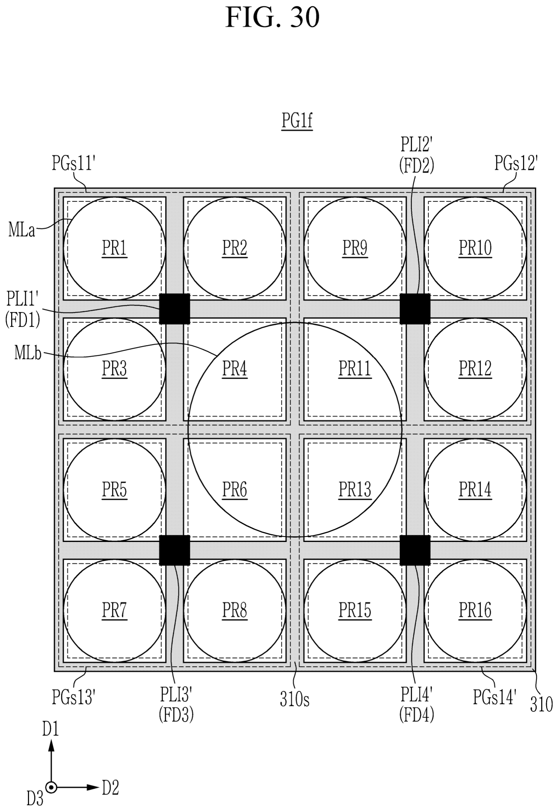

FIG. 30 is a plan view illustrating examples of pixel groups. Each of the first pixel group PG1f, the a-th micro lens MLa, and the b-th micro lens MLb of FIG. 30 may correspond to the first pixel group PG1b, the a-th micro lens MLa, and the b-th micro lens MLb of FIG. 18, respectively. For ease of explanation below, the first pixel group PG1f, the a-th micro lens MLa, and the b-th micro lens MLb will be described with a focus on differences from the first pixel group PG1b, the a-th micro lens MLa, and the b-th micro lens MLb of FIG. 18.

The a-th micro lens MLa may be positioned on the first photodiode region PR1, the second photodiode region PR2, and the third photodiode region PR3 of the 1_1 sub-pixel group PGs11', respectively. Each of the first photodiode region PR1, the second photodiode region PR2, and the third photodiode region PR3 may correspond to one of the a-th micro lens MLa. The a-th micro lens MLa may be positioned on the ninth photodiode region PR9, the tenth photodiode region PR10, and the twelfth photodiode region PR12 among the 1_2 sub-pixel groups PGs12', respectively. Each of the ninth photodiode region PR9, the tenth photodiode region PR10, and the twelfth photodiode region PR12 may correspond to one of the a-th micro lens MLa. The a-th micro lens MLa may be positioned on the fifth photodiode region PR5, the seventh photodiode region PR7, and the eighth photodiode region PR8 among the 1_3 sub-pixel groups PGs13'. Each of the fifth photodiode region PR5, the seventh photodiode region PR7, and the eighth photodiode region PR8 may correspond to one a-th micro lens MLa. The a-th micro lens MLa may be positioned on the fourteenth photodiode region PR14, the fifteenth photodiode region PR15, and the sixteenth photodiode region PR16 among the 1_4 sub-pixel groups PGs14'. Each of the fourteenth photodiode region PR14, the fifteenth photodiode region PR15, and the sixteenth photodiode region PR16 may correspond to one of the a-th micro lens MLa.

The read-out circuit 130 of FIG. 1 may receive a pixel signal for a photodiode corresponding to the a-th micro lens MLa and generate image data IDTA of FIG. 1.

The b-th micro lens MLb may be arranged across the 1_1 sub-pixel group PGs11' to the 1_4 sub-pixel group PGs14', and may be arranged on the fourth photodiode region PR4, the sixth photodiode region PR6, the eleventh photodiode region PR11, and the thirteenth photodiode region PR13. The fourth photodiode region PR4, the sixth photodiode region PR6, the eleventh photodiode region PR11, and the thirteenth photodiode region PR13 may share the b-th micro lens MLb.

The read-out circuit 130 of FIG. 1 may receive a pixel signal for a photodiode corresponding to the b-th micro lens MLb and generate image data IDTA or phase data PDTA. The read-out circuit 130 of FIG. 1 may receive pixel signals corresponding to photodiodes of the fourth photodiode region PR4 and the sixth photodiode region PR6 located on the left among the fourth photodiode region PR4, the sixth photodiode region PR6, the eleventh photodiode region PR11, and the thirteenth photodiode region PR13 to extract first phase information, and may receive pixel signals corresponding to photodiodes of the eleventh photodiode region PR11 and the thirteenth photodiode region PR13 located on the right to extract second phase information.

The read-out circuit 130 of FIG. 1 may generate phase data PDTA by comparing the first phase information and the second phase information. The read-out circuit 130 may substantially simultaneously receive pixel signals for photodiodes of the fourth photodiode region PR4, the sixth photodiode region PR6, the eleventh photodiode region PR11, and the thirteenth photodiode region PR13 through a separation structure for the first to fourth floating diffusion nodes FD1 to FD4.

Additionally, the read-out circuit 130 may generate image data IDTA based on pixel signals for photodiodes in the fourth photodiode region PR4, the sixth photodiode region PR6, the eleventh photodiode region PR11, and the thirteenth photodiode region PR13.

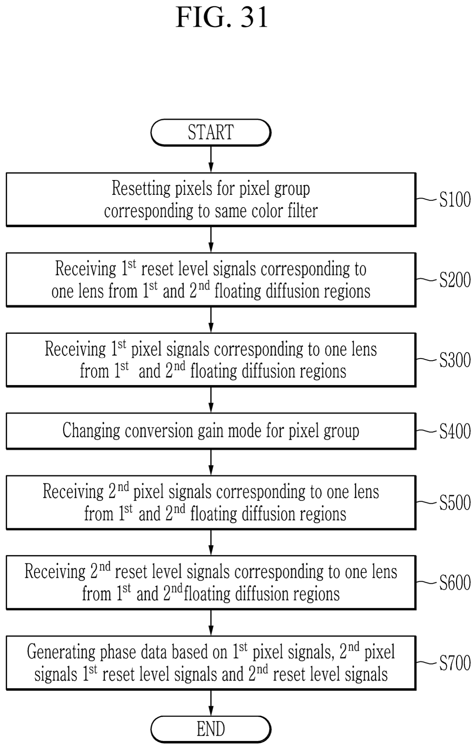

FIG. 31 is a flowchart illustrating an example of a method of operating an image sensor.

Referring to FIG. 31, the image sensor resets pixels of a group of pixels corresponding to the same color filter during the reset period (S100).

In some implementations, a group of pixels on which the same color filter is disposed may include a plurality of sub-pixel groups disposed adjacent to each other, and one sub-pixel group may include a plurality of photodiodes sharing a floating diffusion node. The floating diffusion nodes of different sub-pixel groups may be electrically isolated from each other. In some implementations, a pixel group may include a plurality of photodiodes arranged in a 4x4 arrangement, and a sub-pixel group may include a plurality of photodiodes arranged in a 2x4 or 2x2 arrangement.

In some implementations, shared lenses shared across the plurality of photodiodes may be arranged across different sub-pixel groups within a single pixel group. Through the arrangement of the above shared lenses, the sharing relationship of the micro lenses to the plurality of photodiodes and the sharing relationship of the floating diffusion nodes to the plurality of photodiodes within one pixel group may be misaligned. In some implementations, the shared lens may be arranged on a plurality of photodiodes in a 2x2 arrangement, and the plurality of photodiodes receiving incident light through the shared lens may be used for image generation and phase detection purposes.

A pixel group of the pixel array receives a reset signal and a conversion gain enable signal, and charges existing in a photodiode, a floating diffusion node, and a MIM capacitor within a pixel group of the pixel array may be drained to a power line and reset.

During the integration period following the reset period, the photodiode of the image sensor may be exposed to light and photoelectrically converted to generate photocharges.

The read-out circuit receives a plurality of first reset level signals corresponding to one shared lens from first and second floating diffusion nodes separated from each other (S200).

The read-out circuit may receive the plurality of first reset level signals corresponding to one shared lens from floating diffusion nodes for separate groups of sub-pixels.

Referring to the first pixel group PG1a of FIG. 2 and FIG. 7 as an example, the read-out circuit may receive a plurality of first reset level signals for the 1_1 sub-pixel group PGs11 and the 1_2 sub-pixel group PGs12 sharing the b-th micro lens MLb during the read-out period from the first and second floating diffusion nodes FD1, FD2. In some implementations, the plurality of first reset level signals are pixel signals in a high conversion gain mode and may include a left pixel signal for the first floating diffusion node FD1 and a right pixel signal for the second floating diffusion node FD2.

Referring to the first pixel group PG1b of FIGS. 18 and 19 as an example, the read-out circuit may receive a plurality of first reset level signals for the 1_1 sub-pixel group PGs11' and the 1_2 sub-pixel group PGs12' that share the b-th micro lens MLb during the read-out period from the first and second floating diffusion nodes FD1, FD2. In some implementations, the plurality of first reset level signals are pixel signals in a high conversion gain mode and may include a left pixel signal for the first floating diffusion node FD1 and a right pixel signal for the second floating diffusion node FD2.

During the read-out period following the integration period, a plurality of exposure operation may be performed in which the plurality of exposure operations are performed on the photodiodes within the pixel group.

The read-out circuit receives a plurality of first pixel signals corresponding to one shared lens from first and second floating diffusion nodes separated from each other (S300).

The read-out circuit may receive the plurality of first pixel signals for different sub-pixel groups corresponding to one shared lens from separate floating diffusion nodes.

Referring to the first pixel group PG1a of FIG. 2 and FIG. 7 as an example, the read-out circuit may receive a plurality of first pixel signals for the fourth photodiode PD4 and the sixth photodiode PD6 of the 1_1 sub-pixel group PGs11 and the eleventh photodiode PD11 and the thirteenth photodiode PD13 of the 1_2 sub-pixel group PGs12 that share the b-th micro lens MLb during the read-out period from different first and second floating diffusion nodes FD1, FD2. In some implementations, the plurality of first pixel signals are pixel signals in a high conversion gain mode and may include a left pixel signal for the first floating diffusion node FD1 and a right pixel signal for the second floating diffusion node FD2.

Referring to the first pixel group PG1b of FIGS. 18 and 19 as an example, the read-out circuit may receive a plurality of first pixel signals for the second photodiode PD2 and the fourth photodiode PD4 of the 1_1 sub-pixel group PGs11' that share the b-th micro lens MLb during the read-out period and the ninth photodiode PD9 and the eleventh photodiode PD11 of the 1_2 sub-pixel group PGs12' from different first and second floating diffusion nodes FD1, FD2. In some implementations, the plurality of first pixel signals are pixel signals in a high conversion gain mode and may include a left pixel signal for the first floating diffusion node FD1 and a right pixel signal for the second floating diffusion node FD2.

The pixel group varies the conversion gain mode (S400).

A group of pixels in the pixel array may receive a pixel drive signal to control the operation of a conversion gain transistor and a reset transistor, and an electrical connection between a floating diffusion node and a MIM capacitor may be controlled.

Referring to the first pixel group PG1a of FIG. 2 and FIG. 7 as an example, the first and second middle conversion gain transistors MX1, MX2 are turned on and the first and second low conversion gain transistors LX1, LX2 are turned off, so that the first floating diffusion node FD1 may be electrically connected to one electrode of the first MIM capacitor MIM1 and the second floating diffusion node FD2 may be electrically connected to one electrode of the third MIM capacitor MIM3. In some implementations, the conversion gain mode of the first pixel group PG1a may be varied from a high conversion gain mode to a middle conversion gain mode. Additionally, the first and second middle conversion gain transistors MX1, MX2 are turned on, the first and second low conversion gain transistors LX1, LX2 are turned on, and the first and second reset transistors RX1, RX2 are turned off, so that the first floating diffusion node FD1 may be electrically connected to one electrode of the first and second MIM capacitors MIM1, MIM2, and the second floating diffusion node FD2 may be electrically connected to one electrode of the third and fourth MIM capacitors MIM3, MIM4. In some implementations, the conversion gain mode of the first pixel group PG1a may be changed from a middle conversion gain mode to a low conversion gain mode.

Referring to the first pixel group PG1b of FIGS. 18 and 19 as an example, the first and second low conversion gain transistors LX1, LX2 are turned on and the first and second reset transistors RX1, RX2 are turned off, so that the first floating diffusion node FD1 may be electrically connected to one electrode of the first MIM capacitor MIM1 and the second floating diffusion node FD2 may be electrically connected to one electrode of the third MIM capacitor MIM3. In some implementations, the conversion gain mode of the first pixel group PG1b may be changed from a high conversion gain mode to a low conversion gain mode.

The read-out circuit receives a plurality of second pixel signals corresponding to one shared lens from first and second floating diffusion nodes that are separated from each other (S500).

The read-out circuit may receive the plurality of second pixel signals for different sub-pixel groups corresponding to a single shared lens from separate floating diffusion nodes.

Referring to the first pixel group PG1a of FIG. 2 and FIG. 7 as an example, the read-out circuit may receive a plurality of second pixel signals for the fourth photodiode PD4 and the sixth photodiode PD6 of the 1_1 sub-pixel group PGs11 and the eleventh photodiode PD11 and the thirteenth photodiode PD13 of the 1_2 sub-pixel group PGs12 that share the b-th micro lens MLb during the read-out period from different first and second floating diffusion nodes FD1, FD2. In some implementations, the plurality of second pixel signals are pixel signals in a middle conversion gain mode or a low conversion gain mode and may include a left pixel signal for the first floating diffusion node FD1 and a right pixel signal for the second floating diffusion node FD2.

Referring to the first pixel group PG1b of FIGS. 18 and 19 as an example, the read-out circuit may receive a plurality of second pixel signals for the second photodiode PD2 and the fourth photodiode PD4 of the 1_1 sub-pixel group PGs11' that share the b-th micro lens MLb during the read-out period and the ninth photodiode PD9 and the eleventh photodiode PD11 of the 1_2 sub-pixel group PGs12' from different first and second floating diffusion nodes FD1, FD2. In some implementations, the plurality of second pixel signals are pixel signals in a low conversion gain mode and may include a left pixel signal for the first floating diffusion node FD1 and a right pixel signal for the second floating diffusion node FD2.

The read-out circuit receives a plurality of second reset level signals corresponding to one shared lens from first and second floating diffusion nodes separated from each other (S600).

The read-out circuit may receive the plurality of second reset level signals corresponding to one shared lens from floating diffusion nodes for separate groups of subpixels.

Referring to the first pixel group PG1a of FIG. 2 and FIG. 7 as an example, the read-out circuit may receive a plurality of second reset level signals for the 1_1 sub-pixel group PGs11 and the 1_2 sub-pixel group PGs12 sharing the b-th micro lens MLb during the read-out period from the first and second floating diffusion nodes FD1, FD2. In some implementations, the plurality of second reset level signals are pixel signals in a low conversion gain mode and may include a left pixel signal for the first floating diffusion node FD1 and a right pixel signal for the second floating diffusion node FD2.

Referring to the first pixel group PG1b of FIGS. 18 and 19 as an example, the read-out circuit may receive a plurality of second reset level signals for the 1_1 sub-pixel group PGs11' and the 1_2 sub-pixel group PGs12' sharing the b-th micro lens MLb during the read-out period from the first and second floating diffusion nodes FD1, FD2. In some implementations, the plurality of second reset level signals are pixel signals in a low conversion gain mode and may include a left pixel signal for the first floating diffusion node FD1 and a right pixel signal for the second floating diffusion node FD2.

The read-out circuit generates phase data from a plurality of first pixel signals, a plurality of second pixel signals, a plurality of first reset level signals, and a plurality of second reset level signals (S700).

The read-out circuit may generate phase data by performing a comparison operation from a plurality of first pixel signals, a plurality of second pixel signals, a plurality of first reset level signals, and a plurality of second reset level signals.

Since each of the plurality of first pixel signals, the plurality of second pixel signals, the plurality of first reset level signals, and the plurality of second reset level signals includes left and right pixel signals, the read-out circuit may easily generate phase data by receiving the left and right pixel signals together without receiving the pixel signals in the RSS manner.

The image sensor adopts a structure in which the sharing relationship of micro lenses and the sharing relationship of floating diffusion nodes are misaligned in a pixel array structure sharing floating diffusion nodes, so that left and right pixel signals corresponding to one shared lens may be simultaneously generated from separated floating diffusion nodes. The image sensor may easily perform AF operation in high-light environments while increasing resolution through the shared structure described above. In addition, the image sensor may easily perform AF operation in the plurality of conversion gain modes while increasing resolution through the shared structure as described above, thereby easily performing AF operation even in a wide dynamic range.

In some example implementations a pixel group on which a single colour filter is disposed includes 2x4 sub-pixel groups that share one floating diffusion node each, and a 2x2 auto-focus lens is disposed across different sub-pixel groups. Additionally, a LOFIC capacitor may be implemented as a MIM capacitor on the wiring for each sub-pixel group. Even when an overflow occurs during operation in a LOFIC node the charge for the left and right autofocus data is acquired thought different FD nodes, thereby enabling autofocus operation. Phase information as well as image information can be acquired through the pixel group on which the AF lens is disposed, thereby enabling accurate focus adjustment and high-quality image generation.

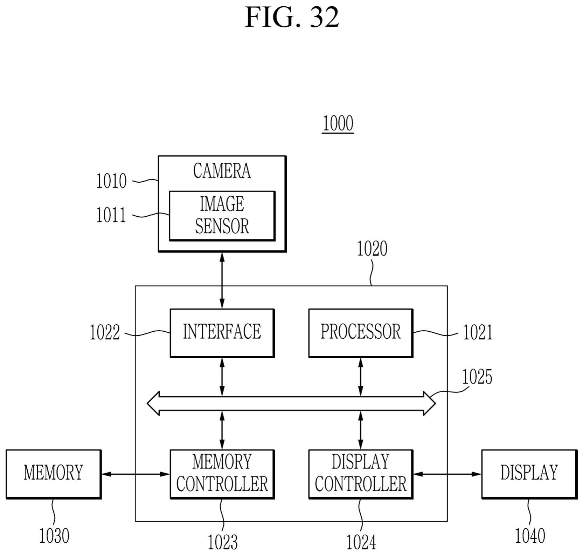

FIG. 32 is a block diagram illustrating an example of a computer device.

Referring to FIG. 32, a computing device 1000 may include a camera 1010, a controller 1020, a memory 1030, and a display 1040.

The camera 1010 may include an image sensor 1011. The image sensor 1011 may be implemented as the image sensor described above in FIGS. 1 to 31. The camera 1010 may generate an image signal using an image sensor 1011, perform image signal processing on the image signal, and output the processed image signal to the controller 1020.

The image sensor 1011 adopts a structure in which the sharing relationship of the micro lenses of a plurality of photodiodes and the sharing relationship of the floating diffusion nodes of a plurality of photodiodes are misaligned in a pixel array structure sharing a floating diffusion node, so that left and right pixel signals corresponding to one shared lens may be simultaneously generated from floating diffusion nodes separated from each other. The image sensor may easily perform AF operation in high-light environments while increasing resolution through the shared structure described above. In addition, the image sensor may easily perform AF operation in the plurality of conversion gain modes while increasing resolution through the shared structure as described above, thereby easily performing AF operation even in a wide dynamic range.

The controller 1020 may include a processor 1021. The processor 1021 may control the overall operation of each component of the computing device 1000. The processor 1021 may be implemented as at least one of various processing units such as a CPU (central processing unit), an AP (application processor), and a GPU (graphic processing unit). In some implementations, the controller 1020 may be implemented as an integrated circuit or a system on chip (SoC).

The controller 1020 may further include an interface 1022, a memory controller 1023, a display controller 1024, and a bus 1025. In some implementations, at least some of the interface 1022, memory controller 1023, display controller 1024, and bus 1025 may be provided external to the controller 1020. In some implementations, the controller 1020 may further include an image signal processor. The controller 1020 may correspond to the image signal processor 160 of FIG. 1.

The interface 1022 may transmit an image signal received from the image sensor 1011 to the memory controller 1023 or the display controller 1024 through the bus 1025.

Memory 1030 may store various data and commands. The memory controller 1023 may control the transfer of data or commands to and from the memory 1030.

The display controller 1024 transmits data to be displayed on the display 1040 to the display 1040 under the control of the processor 1021, and the display 1040 may display a screen according to the received data. In some implementations, the display 1040 may further include a touch screen. The touch screen may transmit user input to the controller 1020 that may control the operation of the computing device 1000. User input may be generated when a user touches a touch screen.

The bus 1025 may provide communication capabilities between components of the controller 1020. The bus 1025 may include at least one type of bus depending on the communication protocol between the components.

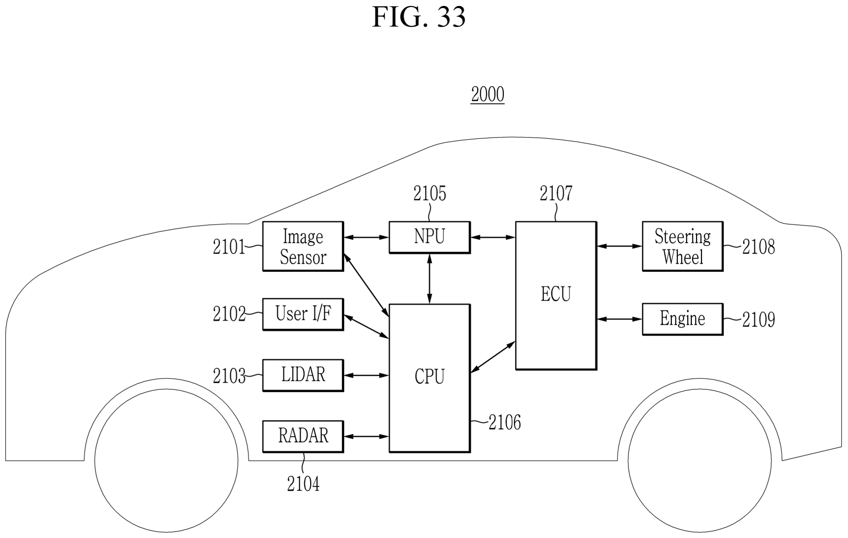

FIG. 33 is a block diagram illustrating an example of a vehicle.

Referring to FIG. 33, the vehicle 2000 may include an image sensor 2101, a user interface 2102, a LIDAR (Light Detection And Ranging) sensor 2103, a RADAR (RAdio Detection And Ranging) sensor 2104, an NPU (Neural Processing Unit) 2105, a CPU 2106, and an ECU 2107.

The ECU 2107 may receive the steering angle of the vehicle and the speed of the vehicle from the steering wheel 2108 and the engine 2109. Although not illustrated, the vehicle 2000 may further include a communication module, an input/output module, a security module, a power control device, and the like, and may also further include various types of control devices.

The vehicle 2000 may detect objects using information about the external environment acquired through sensors (e.g., an image sensor (2101), a lidar sensor 2103, and/or a radar sensor 2104). Sensors 2101, 2103, 2104 may capture images of objects, measure distances to objects, and transmit the images to processors (e.g., CPU 2106, NPU 2105, and ECU 2107). In addition to the sensors mentioned above, sensors 2101, 2103, 2104 may further include a Time of Flight (ToF) sensor, an ultrasonic sensor, an infrared sensor, a magnetic sensor, a position sensor (e.g., GPS), an acceleration sensor, a barometric pressure sensor, a temperature/humidity sensor, a proximity sensor, and a gyroscope sensor to detect objects.

The image sensor 2101 may be implemented as the image sensor described above in FIGS. 1 to 31. The image sensor 2101 may provide image or light sensing and may be, for example, a complementary metal-oxide-semiconductor (CMOS) image sensor. An image sensor 2101 may obtain image or visual information about an object. For example, an image sensor 2101 may be attached to the front of a vehicle to capture driving images or measure the distance to an object located in front of the vehicle. The location where the image sensor 2101 is attached is not limited to this, and it may be attached to various locations to achieve the intended purpose of obtaining information about the object.

The image sensor 2101 may capture images of the environment surrounding the vehicle 2000. The vehicle 2000 may include at least two image sensors to capture 360-degree images around the vehicle. In some implementations, the image sensor 2101 may be equipped with a wide-angle lens. In an implementation, four image sensors may be included in the vehicle 2000, for the front, rear, left side, and right side of the vehicle, but is not limited thereto, and a single image sensor 2101 may also be used to capture the environment surrounding the vehicle. The image sensor 2101 may continuously provide information about the surrounding environment of the vehicle to the vehicle 2000 by continuously capturing images of the surrounding environment of the vehicle.

An image sensed by the image sensor 2101 may be processed by the CPU 2106 and/or the NPU 2105. The CPU 2106 may detect an object by processing a sensed image in a motion-based manner, and the NPU 2105 may detect an object by processing a sensed image in a shape-based manner. The image sensor 2101 may be attached to the front of the vehicle to sense the external environment in front of the vehicle, but is not limited thereto and may be attached to various surfaces of the vehicle to sense the external environment.

The image sensor 2101 adopts a structure in which the sharing relationship of the micro lenses of a plurality of photodiodes and the sharing relationship of the floating diffusion nodes of a plurality of photodiodes are misaligned in a pixel array structure sharing a floating diffusion node, so that left and right pixel signals corresponding to one shared lens may be simultaneously generated from floating diffusion nodes separated from each other. The image sensor may easily perform AF operation in high-light environments while increasing resolution through the shared structure described above. In addition, the image sensor may easily perform AF operation in the plurality of conversion gain modes while increasing resolution through the shared structure as described above, thereby easily performing AF operation even in a wide dynamic range.

The user interface 2102 may include various electronic devices and mechanical devices included in the driver's seat or passenger seat, such as the vehicle's instrument panel, a display showing driving information, a navigation system, and an air conditioning system.

The LIDAR sensor 2103 may measure the distance to an object by emitting a laser pulse and receiving the laser reflected from the object. A LIDAR sensor 2103 may typically include a laser, a scanner, a receiver, and a positioning system. Lasers generally use light with a wavelength of 600 to 1000 nm (nm), but this may vary depending on the application. A scanner may quickly obtain information about the surrounding environment by scanning the surrounding environment being sensed, and there may be various types of scanners using the plurality of mirrors. The receiver may receive the laser pulse reflected from the target object, and detect and amplify the photons from the laser pulse. A positioning system may determine the position coordinates and direction of a device equipped with a receiver to implement a three-dimensional image. The LIDAR sensor 2103 and the RADAR sensor 2104 may be distinguished according to the effective measurement distance.

The RADAR sensor 2104 may measure the distance to an object by emitting electromagnetic waves and receiving the electromagnetic waves reflected from the target object, identify the object, and measure the position and moving speed of the object. The RADAR sensor 2104 may include a transmitter and a receiver. The transmitter may generate and output electromagnetic waves, and the receiver may receive echo waves reflected from a target object and process signals. The RADAR sensor 2104 may transmit and receive via a single antenna, but is not limited thereto. The frequency band of electromagnetic waves used in the RADAR sensor 2104 is a radio wave band or a microwave band, but may be changed depending on the purpose. In an implementation, a LIDAR sensor 2103 and a RADAR sensor 2104 may be attached to the vehicle to assist in determining the relative positional relationship between the vehicle and an object of interest. RADAR sensors 2104 may be divided into long radar sensors and short radar sensors.

NPU 2105 may receive input data, perform calculations using an artificial neural network, and provide output data based on the calculation results. NPU 2105 may be a processor optimized for simultaneous matrix operations, capable of processing the plurality of operations in real time, and capable of learning on its own based on accumulated data to derive optimal values. NPU 2105 is optimized for simultaneous matrix operations and may process the plurality of operations in real time. It may learn on its own based on accumulated data and derive local maxima in the current driving parameters.

In some implementations, the NPU 2105 may be a processor specialized for performing deep-learning type algorithms. For example, the NPU 2105 may be a processor specialized for performing deep-learning algorithms. For example, NPU 2105 is capable of processing operations based on various types of networks such as CNN (Convolution Neural Network), R-CNN (Region with Convolution Neural Network), RPN (Region Proposal Network), RNN (Recurrent Neural Network), Fully Convolutional Network, LSTM (Long Short-Term Memory) Network, and Classification Network. However, it is not limited to this, and various types of computational processing that simulate human neural networks are possible.

The NPU 2105 may receive a driving image from the image sensor 2101 and perform shape-based object detection based on the driving image. NPU 2105 may distinguish each of the plurality of objects in a driving video by extracting features of the plurality of objects and learning on its own based on accumulated data. For example, the NPU 2105 may extract objects that serve as criteria for driving judgment, such as vehicles, pedestrians, traffic lights, and lanes, from a single driving video based on features determined by using accumulated data as learning materials.

The CPU 2106 controls the overall operation of the vehicle 2000. The CPU 2106 may include one processor core (Single Core) or the plurality of processor cores (Multi-Core). The CPU 2106 may process or execute programs and/or data stored in memory. For example, the CPU 2106 may control the functions of the NPU 2105 and the ECU 2107 by executing programs stored in memory.

The CPU 2106 may obtain the steering angle and vehicle speed from the ECU 2107. The steering angle is determined by the driver's operation of the steering wheel 2108, and may be processed by the ECU 2107 that controls the operation of the steering control device and provided to the CPU 2106. The vehicle speed may be measured based on at least one of the driver's pedaling (e.g., operation of the accelerator), the rotational speed of the engine 2109, and the wheel speed measured by the wheel sensor, and may be processed by the ECU 2107 that controls the speed of the vehicle and provided to the CPU 2106.

In addition, the CPU 2106 may determine the relative positional relationship between the vehicle and surrounding vehicles, and issue a command to maintain the rotation speed of the engine 2109 for constant speed driving to maintain a certain distance from surrounding vehicles according to a determined driving plan, and may issue a command to change the steering angle by adjusting the steering wheel 2108 left and right to perform an evasive maneuver when the vehicle and surrounding vehicles are below a critical distance or in a cut-in object situation of a surrounding vehicle. In FIG. 33, the steering wheel 2108 and the engine 2109 are disclosed as configurations related to the steering angle and vehicle speed, but are not limited thereto, and the steering angle and vehicle speed may be determined through various vehicle components.

The CPU 2106 may perform motion-based object detection in a driving video. Motion-based methods are methods that detect the degree of movement of an object over time and determine relative movement. Driving images may be acquired continuously for each frame through an image sensor 2101. For example, each frame may be captured at a rate of 60 frames per second (fps), so that the CPU 2106 may detect movement over time between image frames acquired every 1/60 second. Motion-based methods may include optical flow, which refers to the distribution of motion vectors of objects.

In addition to the image sensor 2101, the CPU 2106 may also supplementally utilize the distance to an object obtained from the LIDAR sensor 2103 and the RADAR sensor 2104 to stably maintain the driving state of the vehicle. Additionally, the CPU 2106 may issue commands to control the state of the interior and exterior of the vehicle according to the driver's operation of the user interface 2102.

The ECU 2107 may be an electronic control device designed to control the overall operation or part of the operation of the vehicle. The ECU 2107 may control vehicle operation according to the operation of the combustion engine, the operation of one or more electric motors, and the vehicle parameters according to the driver's control, such as the operation of a semi-automatic gearbox (SAGB) or an automatic gearbox (AGB) via a Controller Area Network (CAN) multiplexing bus.

The ECU 2107 may electronically control the engine of the vehicle, the actuator of the steering control device, the transmission control system, the anti-lock brake system, the airbag control system, etc. by computer, and may provide the speed of the vehicle to the vehicle 2000 based on the rotation speed of the engine or the wheel speed measured by the wheel sensor, and may provide the steering angle of the vehicle to the vehicle 2000 from the steering control device.

In some implementations, the ECU 2107 may control the state of the steering wheel 2108 and the engine 2109 based on commands issued from the CPU 2106 and the NPU 2105. In an implementation, the ECU 2107 may accelerate or decelerate the vehicle in response to commands issued from the CPU 2106 and the NPU 2105, and may provide a signal to the engine 2109 to increase/decrease engine rotation speed for acceleration/deceleration. Additionally, the ECU 2107 may change the steering wheel 2108 left and right to perform an evasive maneuver when the distance from a surrounding vehicle is below a threshold distance or when a surrounding vehicle cuts in (cut-in object) according to a set driving plan.

In some implementations, the CPU 2106 or the ECU 2107 may identify a failure of the lamp signal (RMP) and exit the autonomous driving mode of the vehicle 2000. For example, the CPU 2106 or ECU 2107 may detect a defect in a lamp signal (RMP) while driving in an autonomous driving mode based on an image sensor 2101, and immediately change the autonomous driving mode to a manual driving mode by the driver, thereby ensuring the safety of the user. For example, the vehicle 2000 may detect a malfunction in the lamp signal (RMP) and stop a driving assistance function based on the lamp signal (RMP), thereby ensuring the safety of the driver or user.

Although the ECU 2107 is depicted in the drawing as being installed in the vehicle separately from the CPU 2106, it is not limited thereto and the vehicle control function of the ECU 2107 may be performed together while being included within the CPU 2106. In this case, the CPU 2106 may be understood to have at least two processor cores (Multi-core). In FIG. 33, the ECU 2107 is depicted as a separate component from the CPU 2106, but is not limited thereto and may exist within the CPU 2106.

Although not illustrated in FIG. 33, the vehicle 2000 may further include a communications module. The communication module may transmit data to the outside of the vehicle 2000 or receive data from the outside. For example, the communication module may communicate with an external object of the vehicle 2000. In this case, the communication module may perform communication in V2X (Vehicle to Everything) mode. For example, the communication module may perform communication in the V2V (Vehicle to Vehicle), V2I (Vehicle to Infra), V2P (Vehicle to Pedestrian), and V2N (Vehicle to Nomadic Devices) modes. However, it is not limited thereto, and the communication module may transmit and receive data by various known communication methods. For example, the communication module may perform communication by, for example, 3G, 4G (LTE), 5G, Wi-Fi, Bluetooth, BLE (Bluetooth Low Energy), Zigbee, NFC (Near Field Communication), ultrasonic communication, etc., and may include both short-range communication and long-range communication.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although the implementations of the present disclosure have been described in detail above, the scope of the present disclosure is not limited thereto, and various modifications and improvements made by those skilled in the art using the basic concept of the present disclosure defined in the following claims also fall within the scope of the present disclosure.

## Claims

1. An image sensor comprising:
a first sub-pixel group (PGs11) including a first plurality of photodiodes (PD1 - PD8), the first plurality of photodiodes (PD1 - PD8) being arranged in a first plurality of rows and a first plurality of columns, and the first plurality of photodiodes (PD1 - PD8) sharing a first floating diffusion node (FD1);
a second sub-pixel group (PGs12) adjacent to the first sub-pixel group (PGs11), the second sub-pixel group (PGs12) including a second plurality of photodiodes (PD9 - PD16), the second plurality of photodiodes (PD9 - PD16) being arranged in a second plurality of rows and a second plurality of columns, and the second plurality of photodiodes (PD9 - PD16) sharing a second floating diffusion node (FD2) separate from the first floating diffusion node (FD1);
a color filter (CF1), wherein at least a portion of the color filter (CF1) is disposed on the first sub-pixel group (PGs11) and the second sub-pixel group (PGs12); and
a first lens (MLb), wherein at least a first portion of the first lens (MLb) overlaps the first sub-pixel group (PGs11) and the second sub-pixel group (PGs12) in a plan view.

2. The image sensor of claim 1 comprising:
a first Metal-Insulator-Metal, MIM, capacitor (MIM1), wherein at least a portion of the first MIM capacitor (MIM1) overlaps the first sub-pixel group (PGs11) in the plan view; and
a second MIM capacitor (MIM2), wherein at least a portion of the second MIM capacitor (MIM2) overlaps the second sub-pixel group (PGs12) in the plan view.

3. The image sensor of claim 2 comprising:
a first conversion gain transistor (MX1) electrically connected between the first floating diffusion node (FD1) and a first electrode of the first MIM capacitor (MIM1); and
a reset transistor (RX1) electrically connected between a second electrode of the first MIM capacitor (MIM1) and a power line configured to provide a power voltage.

4. The image sensor of claim 2 or 3 comprising:
a third MIM capacitor (MIM3), wherein at least a portion of the third MIM capacitor (MIM3) overlaps the first sub-pixel group (PGs11) in the plan view and is separate from the first MIM capacitor (MIM1) in the plan view; and
a fourth MIM capacitor (MIM4), wherein at least a portion of the fourth MIM capacitor (MIM4) overlaps the second sub-pixel group (PGs12) in the plan view and is separate from the second MIM capacitor (MIM2) in the plan view.

5. The image sensor of claim 4, wherein:
the first MIM capacitor (MIM1) includes a first metal film and a second metal film that overlap each other in the plan view,
the third MIM capacitor (MIM3) includes a third metal film and a fourth metal film that overlap each other in the plan view,
an area of the first metal film and an area of the third metal film are different from each other, and
the first MIM capacitor (MIM1) and the third MIM capacitor (MIM3) have different charge storage capacities.

6. The image sensor of any one of claims 1 to 5, wherein:
the first plurality of photodiodes (PD1 - PD8) are arranged in a first photodiode region to an eighth photodiode region (PR1 to PR8) in a 4x2 arrangement, and
the second plurality of photodiodes (PD9 - PD16) are arranged in a ninth photodiode region to a sixteenth photodiode region (PR9 to PR16) in a 4x2 arrangement.

7. The image sensor of claim 6 comprising
a plurality of second lenses (MLa) arranged in each photodiode region of the first photodiode region to the sixth photodiode region and the ninth photodiode region to the fourteenth photodiode region,
wherein the seventh photodiode region, the eighth photodiode region, the fifteenth photodiode region, and the sixteenth photodiode region are arranged in a 2×2 arrangement, and
wherein at least a second portion of the first lens (MLb) overlaps the seventh photodiode region (PR7), the eighth photodiode region (PR8), the fifteenth photodiode region (PR15), and the sixteenth photodiode region in the plan view.

8. The image sensor of claim 6 comprising:
a plurality of second lenses (MLa) arranged in each photodiode region of the first photodiode region to the sixth photodiode region and the ninth photodiode region to the fourteenth photodiode region,
wherein the seventh photodiode region and the fifteenth photodiode region are arranged in a 1×2 arrangement, and
wherein at least a second portion of the first lens (MLb) overlaps the seventh photodiode region and the fifteenth photodiode region in the plan view.

9. The image sensor of any one of claims 1 to 8 comprising:
a third sub-pixel group (PGs13') including a third plurality of photodiodes, the third plurality of photodiodes being arranged in a third plurality of rows and a third plurality of columns, and the third plurality of photodiodes sharing a third floating diffusion node separate from the first floating diffusion node (FD1) and the second floating diffusion node (FD2); and
a fourth sub-pixel group (PGs14') including a fourth plurality of photodiodes, the fourth plurality of photodiodes being arranged in a fourth plurality of rows and a fourth plurality of columns, and the fourth plurality of photodiodes sharing a fourth floating diffusion node separate from the first floating diffusion node (FD1) to the third floating diffusion node,
wherein the first sub-pixel group (PGs11) to fourth sub-pixel group (PGs14') are arranged in a 2x2 arrangement, and
wherein the color filter (CF1) is disposed on the first sub-pixel group (PGs11') to the fourth sub-pixel group (PGs14'),
optionally a second lens (MLb), wherein at least a portion of the second lens (MLb) overlaps the third sub-pixel group (PGs13') and the fourth sub-pixel group (PGs14') in the plan view.

10. The image sensor of claim 9, wherein:
at least a second portion of the first lens (MLb) overlaps the first sub-pixel group (PGs11') to the fourth sub-pixel group (PGs14')in the plan view.

11. The image sensor of any one of claims 1 to 10, wherein:
the first plurality of photodiodes (PD1 - PD8) and the second plurality of photodiodes (PD9 - PD16) are included in a substrate (320),
the substrate (320) includes a device isolation pattern (310) configured to position the first plurality of photodiodes (PD1 - PD8) and the second plurality of photodiodes (PD9 - PD16) in a plurality of rows and a plurality of columns.

12. The image sensor of claim 11 comprising:
a first transfer transistor configured to provide photocharges generated from the first plurality of photodiodes (PD1 - PD8) to the first floating diffusion node (FD1), and
a second transfer transistor (TX2) configured to provide photocharges generated from the second plurality of photodiodes (PD9 - PD16) to the second floating diffusion node (FD2),
wherein the substrate (320) includes a first surface and a second surface opposite to the first surface, and the first transfer transistor and the second transfer transistor are on the first surface, and
wherein at least a portion of the first floating diffusion node (FD1) includes a conductive pattern contacting at least a portion of the first surface.

13. The image sensor of any one of claims 1 to 12, wherein the color filter (CF1) is a red color filter or a blue color filter.

14. The image sensor of any one preceding claim comprising:
a first photodiode (PD) configured to receive light through the first lens (MLb) to generate photocharges, the first photodiode (PD) being electrically connected to a first floating diffusion node (FD1) through a first transfer transistor (TX);
a second photodiode (PD) configured to receive light through a second lens (MLa) to generate photocharges, the second photodiode (PD) being electrically connected to the first floating diffusion node (FD1) through a second transfer transistor;
a first driving transistor (DX1) configured to generate a first pixel signal based on a voltage of the first floating diffusion node (FD1);
a third photodiode (PD) configured to receive light through the first lens (MLb) to generate photocharges, the third photodiode (PD) being electrically connected to a second floating diffusion node (FD2) through a third transfer transistor, the second floating diffusion node (FD2) being separate from the first floating diffusion node (FD1);
a fourth photodiode (PD) configured to receive light through a third lens (MLa) to generate photocharges, the fourth photodiode (PD) being electrically connected to the second floating diffusion node (FD2) through a fourth transfer transistor (TX);
a second driving transistor (DX2) configured to generate a second pixel signal based on a voltage of the second floating diffusion node (FD2);
a color filter (CF1), wherein at least a portion of the color filter (CF1) is disposed on the first photodiode (PD) to the fourth photodiode (PD); and
a read-out circuit (130) configured to receive the first pixel signal through a first column line and to receive the second pixel signal through a second column line to generate image data based on the first pixel signal and the second pixel signal, the second column line being separate from the first column line.

15. A method of operating an image sensor comprising:
resetting a first sub-pixel group (PGs11) and a second sub-pixel group (PGs12), wherein the first sub-pixel group (PGs11) shares a first floating diffusion node (FD1) and is configured to output a pixel signal for a first color, wherein the second sub-pixel group (PGs12) shares a second floating diffusion node (FD2) separate from the first floating diffusion node (FD1) and is configured to output a pixel signal for the first color, and wherein at least a portion of the first sub-pixel group (PGs11) and at least a portion of the second sub-pixel group (PGs12) overlap a first lens (MLb) in a plan view;
receiving a first reset level signal from the first floating diffusion node (FD1) and receiving a second reset level signal from the second floating diffusion node (FD2);
receiving a first pixel signal from the first floating diffusion node (FD1) and receiving a second pixel signal from the second floating diffusion node (FD2) in a first conversion gain mode;
changing the first conversion gain mode to a second conversion gain mode for the first sub-pixel group (PGs11) and the second sub-pixel group (PGs12);
receiving a third pixel signal from the first floating diffusion node (FD1) and receiving a fourth pixel signal from the second floating diffusion node (FD2) in the second conversion gain mode; and
generating phase data based on the third pixel signal and the fourth pixel signal.
